# EUROPEAN PATENT APPLICATION

(11) **EP 4 213 301 A1**
(43) Date of publication of application: **19.07.2023**
(21) Application number: 21874143.7
(22) Date of filing: 26.08.2021
(51) Int. Cl.: H01Q 1/36, H01Q 1/38

(54) **ANTENNA AND PREPARATION METHOD THEREFOR, AND MILLIMETER-WAVE SENSOR AND TERMINAL**

(30) Priority: 30.09.2020 CN 202011066537
(71) Applicant: Huawei Technologies Co., Ltd., Shenzhen, Guangdong 518129 (CN)
(72) Inventor: YU, Tingting, Shenzhen, Guangdong 518129 (CN); LI, Haowei, Shenzhen, Guangdong 518129 (CN); GAO, Xiang, Shenzhen, Guangdong 518129 (CN); LIU, Yiting, Shenzhen, Guangdong 518129 (CN); YAN, Chen, Shenzhen, Guangdong 518129 (CN)
(74) Representative: Gill Jennings & Every LLP
(86) International application number: PCT/CN2021/114809
(87) International publication number: WO 2022/068482

(57) **Abstract**

Embodiments of this application provide an antenna and a preparation method thereof, a millimeter-wave sensor, and a terminal. Gaps exist between a plurality of coupling stubs and a microstrip feeder. In this way, a resonant structure (namely, LC) is formed between the plurality of coupling stubs and the microstrip feeder, so that the antenna generates another resonance. In this way, the antenna can generate two resonance points, to implement a larger bandwidth, increase a range resolution of a millimeter-wave radar, and resolve a problem that a bandwidth of an existing antenna cannot meet a use requirement of the millimeter-wave radar in a long range scenario and a middle range scenario. Further, the method improves an advanced driving assistance system (ADAS) capability of the terminal in self-driving or assisted driving, and may be applied to the internet of vehicles, for example, vehicle-to-everything (V2X), long term evolution-vehicle (LTE-V), and vehicle-to-vehicle (V2V).

## Description

This application claims priority to Chinese Patent Application No. 202011066537.X, filed with the China National Intellectual Property Administration on September 30, 2020 and entitled "ANTENNA AND PREPARATION METHOD THEREOF, MILLIMETER-WAVE SENSOR, AND TERMINAL", which is incorporated herein by reference in its entirety.

### TECHNICAL FIELD

This application relates to the field of antenna technologies, and in particular, to an antenna and a preparation method thereof, a millimeter-wave sensor, and a terminal.

### BACKGROUND

A radar (Radar) is an electronic device that uses an electromagnetic wave to detect a target. The radar emits the electromagnetic wave to irradiate the target and receives an echo of the target. In this way, the radar obtains information such as a distance from the target to an electromagnetic wave emission point, a distance change rate (a radial velocity), an azimuth, and a height. The radar may be classified into an over-the-horizon radar, a microwave radar, a millimeter-wave radar, and a laser radar based on a radar frequency band. The millimeter-wave radar is a radar operating on a millimeter wave (millimeter wave) band for detection. The millimeter wave band refers to a band in a frequency domain of 30 GHz to 300 GHz (a wavelength is 1 mm to 10 mm). A wavelength of the millimeter wave is between a microwave and a centimeter wave. Because a transmission wavelength of the millimeter-wave radar is within a millimeter range, a size of an antenna required for a millimeter-wave signal is very small.

Currently, the antenna is mainly used in the millimeter-wave radar to transmit or receive an electromagnetic wave. The antenna is disposed on a circuit board. A plurality of columns of antennas form an antenna array. However, an existing antenna has a small bandwidth, and cannot well meet a use requirement of the millimeter-wave radar in a long range scenario and a middle range scenario. Therefore, how to increase a bandwidth of an antenna is an urgent problem to be resolved for a millimeter-wave radar.

### SUMMARY

This application provides an antenna and a preparation method thereof, a millimeter-wave sensor, and a terminal, to implement dual resonance through gap coupling, expand a bandwidth of an antenna, and resolve a problem that a bandwidth of an existing antenna cannot well meet a use requirement of a millimeter-wave radar in a long range scenario and a middle range scenario.

A first aspect of embodiments of this application provides an antenna, including a microstrip feeder disposed on one surface of a dielectric plate. The antenna further includes at least one of a first group of radiating elements located on a first side of the microstrip feeder or a second group of radiating elements located on a second side of the microstrip feeder. The first group of radiating elements includes at least one first coupling stub. The second group of radiating elements includes at least one second coupling stub.

A gap exists between the at least one first coupling stub and/or the at least one second coupling stub and the microstrip feeder.

The gap exists between the at least one first coupling stub and/or the at least one second coupling stub and the microstrip feeder. In this way, a resonant structure (namely, LC) is formed between the at least one first coupling stub and/or the at least one second coupling stub and the microstrip feeder, so that the antenna generates another resonance. In this way, the antenna can generate two resonance points, to implement a larger bandwidth, increase a long range resolution of a millimeter-wave radar, and meet a use requirement of the radar in a short range scenario, a middle range scenario, and a long range scenario. Therefore, the antenna provided in this embodiment of this application covers a larger bandwidth, and resolves a problem that a bandwidth of an existing antenna cannot meet a use requirement of a millimeter-wave radar in a middle range scenario and a long range scenario.

In a possible implementation, a quantity of the at least one first coupling stub is greater than or equal to 3, and/or a quantity of the at least one second coupling stub is greater than or equal to 3.

Widths of gaps between the at least one first coupling stub and the microstrip feeder satisfy a rule of first decreasing and then increasing from a first end to a second end of the microstrip feeder; and/or
widths of gaps between the at least one second coupling stub and the microstrip feeder satisfy a rule of first decreasing and then increasing from a first end to a second end of the microstrip feeder.

The widths of the gaps between the at least one first coupling stub and/or the at least one second coupling stub and the microstrip feeder first decrease and then increase from the first end to the second end of the microstrip feeder. This implements low sidelobe effect, reduces a false alarm probability of a minor lobe level for a millimeter-wave sensor, and avoids a false alarm problem of a radar as much as possible. Therefore, the antenna provided in this embodiment of this application increases a bandwidth, implements low sidelobe effect, and resolves a problem that a bandwidth and a low sidelobe in an existing antenna cannot be met at the same time.

In a possible implementation, a sum of the quantity of the at least one first coupling stub and the quantity of the at least one second coupling stub is greater than or equal to 3.

The widths of the gaps between the at least one first coupling stub and the microstrip feeder and the widths of the gaps between the at least one second coupling stub and the microstrip feeder satisfy the rule of first decreasing and then increasing from the first end to the second end of the microstrip feeder. The widths of the gaps between the at least one first coupling stub and/or the at least one second coupling stub and the microstrip feeder first decrease and then increase from the first end to the second end of the microstrip feeder. This implements low sidelobe effect, reduces a false alarm probability of a minor lobe level for a millimeter-wave sensor, and avoids a false alarm problem of a radar as much as possible.

In a possible implementation, the at least one first coupling stub and the at least one second coupling stub are alternately distributed on two sides of the microstrip feeder.

In a possible implementation, the quantity of the at least one first coupling stub is greater than or equal to 3, and/or the quantity of the at least one second coupling stub is greater than or equal to 3.

Widths of the at least one first coupling stub satisfy a rule of first increasing and then decreasing from the first end to the second end of the microstrip feeder; and/or
widths of the at least one second coupling stub satisfy a rule of first increasing and then decreasing from the first end to the second end of the microstrip feeder.

The widths of the at least one first coupling stub and/or the at least one second coupling stub first increase and then decrease from one end to the other end of the microstrip feeder. This implements low sidelobe effect, reduces a false alarm probability of a minor lobe level for a millimeter-wave sensor, and avoids a false alarm problem of a radar as much as possible.

In a possible implementation, the sum of the quantity of the at least one first coupling stub and the quantity of the at least one second coupling stub is greater than or equal to 3.

The widths of the at least one first coupling stub and the widths of the at least one second coupling stub satisfy the rule of first increasing and then decreasing from the first end to the second end of the microstrip feeder.

In a possible implementation, the first group of radiating elements and the second group of radiating elements include two groups of adjacent first coupling stubs and second coupling stubs. Vertical distances between adjacent first coupling stubs and second coupling stubs in the two groups are different. This can implement a low sidelobe.

In a possible implementation, vertical distances between adjacent first coupling stubs and second coupling stubs in any two groups included in the first group of radiating elements and the second group of radiating elements are different. This can implement a low sidelobe.

In a possible implementation, a distance between the first coupling stub and the second coupling stub that are adj acent to each other in any group included in the first group of radiating elements and the second group of radiating elements is d1 millimeters (mm), d1 satisfies 0.4*λ_{g}* ≤ *d*1 ≤ 0.6*λ_{g}*, and *λ_{g}* is a wavelength of an electromagnetic wave transmitted in the dielectric plate by using the first coupling stub or the second coupling stub. This ensures that the coupling stubs implement codirectional superposition, to implement a high gain.

In a possible implementation, a width of a gap between the microstrip feeder and any first coupling stub is greater than or equal to 0.076 mm and less than or equal to 0.9 mm; and/or
a width of a gap between the microstrip feeder and any second coupling stub is greater than or equal to 0.076 mm and less than or equal to 0.9 mm. This can ensure that coupled feeding can be implemented between each coupling stub and the microstrip feeder, to avoid poor coupling effect caused by an excessively large gap and a resonance generation difficulty caused by an excessively small gap.

In a possible implementation, at least one matching stub is disposed on at least one side of one or more first coupling stubs of the at least one first coupling stub; and/or
at least one matching stub is disposed on at least one side of one or more second coupling stubs of the at least one second coupling stub.

A gap exists between the matching stub and the microstrip feeder and between the matching stub and the one or more first coupling stubs and/or the one or more second coupling stubs.

The matching stub is disposed, so that radiation stubs of the antenna increase, and coupling is implemented between the matching stub and the coupling stub, so that a bandwidth covered by the antenna is larger

In a possible implementation, the matching stubs are disposed on upper and lower sides of the any first coupling stub and the any second coupling stub.

In a possible implementation, a length of the at least one first coupling stub and a length of the at least one second coupling stub are greater than or equal to 0.4*λ_{g}* and less than or equal to 0.6*λ_{g}*; or
a length of the any first coupling stub and a length of the any second coupling stub are greater than or equal to 0.4*λ_{g}* and less than or equal to 0.6*λ_{g}*, and *λ_{g}* is a wavelength of an electromagnetic wave transmitted in the dielectric plate by using the first coupling stub or the second coupling stub. This ensures that each coupling stub operates on a required operating frequency band, and ensures that an operating frequency of the antenna can meet a requirement.

In a possible implementation, a width of the at least one first coupling stub and a width of the at least one second coupling stub are greater than or equal to 0.076 mm and less than or equal to 0.9 mm; or
a width of the any first coupling stub and a width of the any second coupling stub are greater than or equal to 0.076 mm and less than or equal to 0.9 mm. When the width of the coupling stub is less than 0.076 mm, it is usually difficult to implement a manufacturing process of the coupling stub. Therefore, in this embodiment of this application, the width of the coupling stub is greater than or equal to 0.076 mm, to meet a process requirement. When the width of the coupling stub is greater than 0.9 mm, because the first coupling stubs and the second coupling stubs are alternately disposed on the two sides of the microstrip feeder, the first coupling stub and the second coupling stub that are adjacent to each other interfere with each other, resulting in a gain increase of the antenna. In addition, a beam form changes, and therefore a requirement cannot be met.

In a possible implementation, the at least one first coupling stub or the at least one second coupling stub or both are rectangular or trapezoidal patches, or the any first coupling stub or the any second coupling stub or both are rectangular or trapezoidal patches.

In a possible implementation, a quantity of the first coupling stubs is 5, and/or a quantity of the second coupling stubs is 5.

A second aspect of embodiments of this application provides a millimeter-wave sensor, including at least a circuit board, a metal ground layer disposed on a first surface of the circuit board, and at least one antenna array disposed on a second surface of the circuit board. One or more antenna arrays in the at least one antenna array include at least one antenna according to any one of the foregoing implementations.

The millimeter-wave sensor provided in this embodiment of this application includes the foregoing antenna, to implement a larger bandwidth, increase a range resolution of the millimeter-wave radar, and meet a requirement for implementing a 5 GHz bandwidth with a long range resolution. In addition, this implements low sidelobe effect, reduces a false alarm probability of a minor lobe level for the millimeter-wave sensor, and avoids a false alarm problem of the millimeter-wave sensor as much as possible.

In a possible implementation, the at least one antenna array includes at least one transmit antenna array and at least one receive antenna array. Any transmit antenna array and any receive antenna array include at least one antenna. A microstrip feeder of the antenna is electrically connected to a feed of the circuit board.

In a possible implementation, a thickness of the circuit board is 5 Mil (mil).

In a possible implementation, a dielectric constant of the circuit board is greater than or equal to 2 and less than or equal to 4.

A third aspect of embodiments of this application provides a terminal, including at least a body and at least one sensor disposed on the body. The at least one sensor includes at least one millimeter-wave sensor according to any one of the foregoing implementations. Further optionally, the terminal may be a vehicle, an unmanned aerial vehicle, a smart home device, a smart manufacturing device, or the like.

The terminal provided in this embodiment of this application includes the foregoing millimeter-wave sensor, to implement a larger bandwidth, increase a range resolution of the millimeter-wave radar, and meet a requirement for implementing a 5 GHz bandwidth with a long range resolution. In addition, this implements low sidelobe effect, reduces a false alarm probability of a minor lobe level for the millimeter-wave sensor, and avoids a false alarm problem as much as possible to ensure most accurate detection of a target.

In a possible implementation, the millimeter-wave sensor is a millimeter-wave radar.

A fourth aspect of embodiments of this application provides a method for preparing an antenna, including:
forming at least one microstrip feeder on one surface of a dielectric plate; and
forming a first group of radiating elements on a first side of the microstrip feeder and/or forming a second group of radiating elements on a second side of the microstrip feeder, where the first group of radiating elements includes at least one first coupling stub, and the second group of radiating elements includes at least one second coupling stub.

A gap is formed between the at least one first coupling stub and/or the at least one second coupling stub and the microstrip feeder.

In a possible implementation, the method further includes:
forming a metal ground layer on the other surface of the dielectric plate.

In a possible implementation, the dielectric plate is a printed circuit board (Printed Circuit Board, PCB).

In a possible implementation, a sum of a quantity of the at least one first coupling stub and a quantity of the at least one second coupling stub is greater than or equal to 3.

Widths of gaps between the at least one first coupling stub and the microstrip feeder and widths of gaps between the at least one second coupling stub and the microstrip feeder satisfy a rule of first decreasing and then increasing from a first end to a second end of the microstrip feeder.

In a possible implementation, the at least one first coupling stub and the at least one second coupling stub are alternately distributed on two sides of the microstrip feeder.

In a possible implementation, the quantity of the at least one first coupling stub is greater than or equal to 3, and/or the quantity of the at least one second coupling stub is greater than or equal to 3.

Widths of the at least one first coupling stub satisfy a rule of first increasing and then decreasing from the first end to the second end of the microstrip feeder, and/or widths of the at least one second coupling stub satisfy a rule of first increasing and then decreasing from the first end to the second end of the microstrip feeder.

In a possible implementation, the sum of the quantity of the at least one first coupling stub and the quantity of the at least one second coupling stub is greater than or equal to 3.

The widths of the at least one first coupling stub and the widths of the at least one second coupling stub satisfy the rule of first increasing and then decreasing from the first end to the second end of the microstrip feeder.

In a possible implementation, the first group of radiating elements and the second group of radiating elements include two groups of adjacent first coupling stubs and second coupling stubs. Distances between adjacent first coupling stubs and second coupling stubs in the two groups are different.

### BRIEF DESCRIPTION OF DRAWINGS

FIG. 1 is a schematic diagram of a structure of an antenna;
FIG. 2A is a schematic diagram of a structure of an antenna according to an embodiment of this application;
FIG. 2B is a schematic diagram of a structure of an antenna according to an embodiment of this application;
FIG. 2C is a schematic diagram of a structure of an antenna according to an embodiment of this application;
FIG. 3A is a schematic diagram of a structure of an antenna according to an embodiment of this application;
FIG. 3B is a schematic diagram of a structure of an antenna according to an embodiment of this application;
FIG. 3C is a schematic diagram of a structure of an antenna according to an embodiment of this application;
FIG. 3D is a schematic diagram of a structure of an antenna according to an embodiment of this application;
FIG. 3E is a schematic simulation diagram of an antenna according to an embodiment of this application;
FIG. 4 is a schematic diagram of a structure of an antenna according to an embodiment of this application;
FIG. 5 is a schematic diagram of a structure of an antenna according to an embodiment of this application;
FIG. 6 is a schematic diagram of a structure of an antenna according to an embodiment of this application;
FIG. 7A is a schematic diagram of a structure of an antenna according to an embodiment of this application;
FIG. 7B is a schematic diagram of a structure of an antenna according to an embodiment of this application;
FIG. 8A is a schematic diagram of a structure of an antenna according to another embodiment of this application;
FIG. 8B is a schematic diagram of a structure of an antenna according to another embodiment of this application;
FIG. 8C is a schematic diagram of a structure of an antenna according to another embodiment of this application;
FIG. 8D is a schematic diagram of a structure of an antenna according to another embodiment of this application;
FIG. 8E is a schematic diagram of a structure of an antenna according to another embodiment of this application;
FIG. 9 is a schematic diagram of a structure of an antenna according to an embodiment of this application;
FIG. 10 is a schematic diagram of a structure of an antenna according to an embodiment of this application;
FIG. 11 is a schematic diagram of a structure of an antenna according to an embodiment of this application;
FIG. 12A is a schematic diagram of a structure of an antenna formed on one surface of a dielectric plate in a method for preparing an antenna according to an embodiment of this application;
FIG. 12B is a schematic diagram of a metal ground layer formed on the other surface of a dielectric plate in a method for preparing an antenna according to an embodiment of this application;
FIG. 13A is a schematic diagram of a structure of a millimeter-wave sensor according to an embodiment of this application;
FIG. 13B is a schematic diagram of a cross-sectional structure in an A-A direction in FIG. 13A; and
FIG. 14 is a schematic diagram of a structure of a terminal according to an embodiment of this application.

### Description of reference numerals:

10-Microstrip feeder; 10a-First end; 10b-Second end; 21-First group of radiating elements;
21a, 21b, 21c, 21d, 21e-First coupling stub; 22-Second group of radiating elements;
22a, 22b, 22c, 22d, 22e-Second coupling stub; 23-Matching stub; 100-Millimeter-wave sensor;
101-Transmit antenna array; 102-Receive antenna array; 200-Circuit board; 200a-Dielectric plate;
210-First surface of a dielectric plate; 220-Second surface of a dielectric plate;
201, 202, 203, 204, 205, 206-Feed point; 300-Metal ground layer; 400-Terminal; 401-Body.

### DESCRIPTION OF EMBODIMENTS

Terms used in embodiments of this application are only used to explain specific embodiments of this application, but are not intended to limit this application.

Main lobe: In a radiation pattern of an antenna, a lobe in a maximum radiation direction is referred to as a main lobe, and a lobe right behind the main lobe is referred to as a back lobe.

Minor lobe (Sidelobe): In the radiation pattern of the antenna, a lobe between the main lobe and the back lobe is referred to as a minor lobe.

Minor lobe level: The minor lobe level indicates a logarithmic value of a ratio of a power density of the minor lobe in the maximum radiation direction to a power density of the main lobe in the maximum radiation direction.

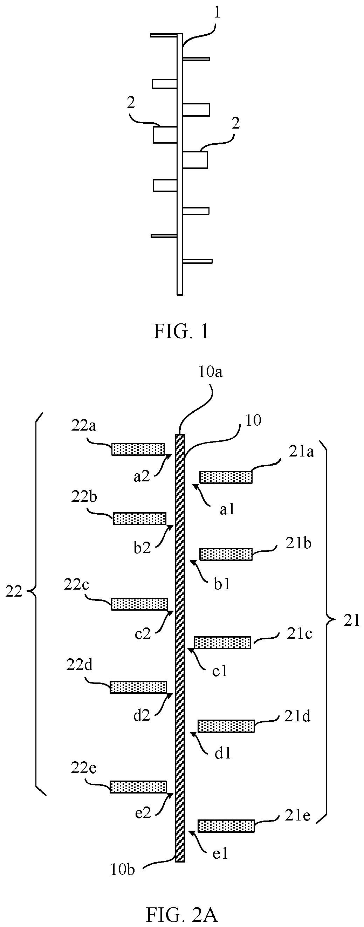

FIG. 1 is a schematic diagram of a structure of an antenna applied to a radar. As shown in FIG. 1, the antenna includes a feeder 1 and a plurality of radiation patches 2 that are electrically in contact with the feeder 1. Widths of the plurality of radiation patches 2 decrease from the middle of the feeder 1 to two ends of the feeder 1. However, when the antenna of this structure is used in the radar, a bandwidth is small (1 GHz), cannot meet a use requirement of the radar in a middle range scenario and a long range scenario, and is not enough to meet a requirement for implementing a 5 GHz bandwidth with a long range resolution.

To resolve the foregoing problem, embodiments of this application provide an antenna, a millimeter-wave sensor, and a terminal. Coupled feeding is implemented between a microstrip feeder and a plurality of coupling stubs. In this way, there is a gap between the coupling stub and the microstrip feeder. By using the gap, a resonant structure (namely, a resonant circuit including an inductor (L) and a capacitor (C), briefly referred to as LC) is formed between the coupling stub and the microstrip feeder, so that another resonance is coupled, and the antenna can generate two resonance points, to implement a larger bandwidth. Therefore, the antenna provided in this embodiment of this application increases a bandwidth, to meet a use requirement of a radar in a short range scenario, a middle range scenario, and a long range scenario, and resolve a problem that a bandwidth of an existing antenna cannot meet a use requirement of the millimeter-wave radar in a middle range scenario and a long range scenario.

The following describes in detail the antenna, the millimeter-wave sensor, and the terminal in embodiments of this application with reference to the accompanying drawings.

### Embodiment 1

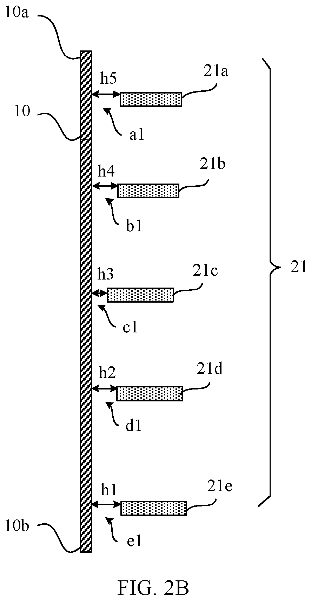

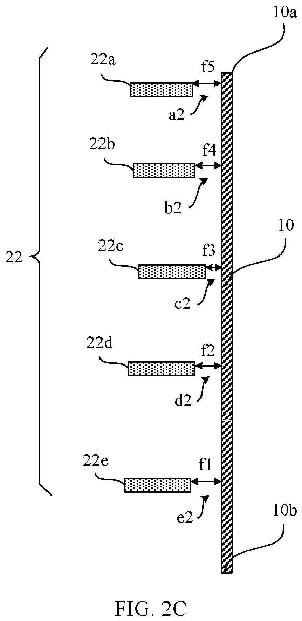

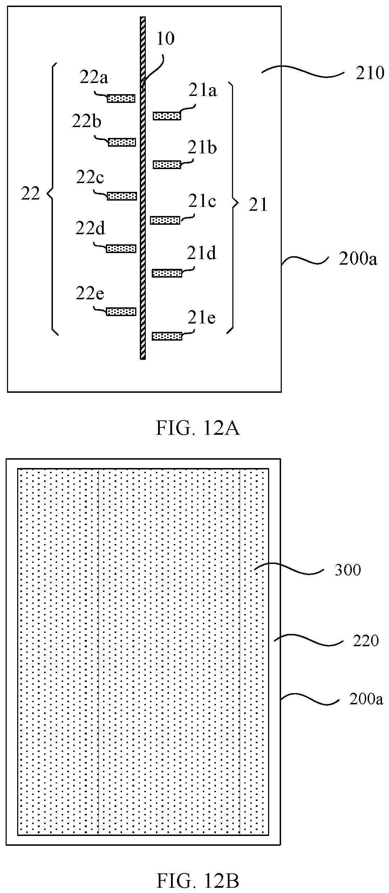

As shown in FIG. 2A, the antenna provided in this embodiment of this application may be a series-fed antenna. The series-fed antenna may be applied to a sensor such as a radar. The antenna may include a microstrip feeder 10. The microstrip feeder 10 may be disposed on one surface of a dielectric plate 200a (in the following descriptions of FIG. 12A). Specifically, the dielectric plate 200a may be a printed circuit board (PCB). The antenna further includes at least one of a first group of radiating elements 21 located on a first side of the microstrip feeder 10 or a second group of radiating elements 22 located on a second side of the microstrip feeder 10. For example, as shown in FIG. 2A, the antenna may include a first group of radiating elements 21 located on a first side (for example, the right side in FIG. 2A) of the microstrip feeder 10 and a second group of radiating elements 22 located on a second side (for example, the left side in FIG. 2A) of the microstrip feeder 10. Alternatively, as shown in FIG. 2B, the antenna may include a first group of radiating elements 21 located on a first side (for example, the right side in FIG. 2B) of the microstrip feeder 10. Alternatively, as shown in FIG. 2C, the antenna further includes a second group of radiating elements 22 located on a second side (for example, the left side in FIG. 2C) of the microstrip feeder 10.

Certainly, in some examples, the first group of radiating elements 21 may be located on the left side of the microstrip feeder 10. The second group of radiating elements 22 is located on the right side of the microstrip feeder 10. One end of the microstrip feeder 10 is electrically connected to a feed (namely, a signal source). The feed feeds a current into the two groups of radiating elements through the microstrip feeder 10. The current may be, for example, a high-frequency current. It should be noted that the high-frequency current is specifically a current provided by an alternating current whose frequency is greater than or equal to 50 Hz, and the current is emitted by the radiating elements in an electromagnetic wave manner.

The first group of radiating elements 21 includes at least one first coupling stub. The second group of radiating elements 22 includes at least one second coupling stub. In an example, as shown in FIG. 2A, the first group of radiating elements 21 includes five first coupling stubs. The five first coupling stubs are respectively a first coupling stub 21a, a first coupling stub 21b, a first coupling stub 21c, a first coupling stub 21d, and a first coupling stub 21e. The second group of radiating elements 22 may include five second coupling stubs. The five second coupling stubs are respectively a second coupling stub 22a, a second coupling stub 22b, a second coupling stub 22c, a second coupling stub 22d, and a second coupling stub 22e. Certainly, in some examples, the first group of radiating elements 21 and the second radiating elements include but are not limited to five coupling stubs. Alternatively, the first group of radiating elements or the second group of radiating elements may include one or more coupling stubs.

Further optionally, as shown in FIG. 2A, when the first coupling stubs and the second coupling stubs are distributed on two sides of the microstrip feeder 10, at least one first coupling stub and at least one second coupling stub are alternately distributed on the two sides of the microstrip feeder 10. For example, as shown in FIG. 2A, the second coupling stub 22a, the first coupling stub 21a, the second coupling stub 22b, the first coupling stub 21b, the second coupling stub 22c, the first coupling stub 21c, the second coupling stub 22d, the first coupling stub 21d, the second coupling stub 22e, and the first coupling stub 21e may be sequentially disposed from a first end to a second end of the microstrip feeder 10.

In a design of this application, a gap exists between the at least one first coupling stub and/or the at least one second coupling stub and the microstrip feeder 10. In this way, coupled feeding is implemented between both of the plurality of first coupling stubs and the plurality of second coupling stubs and the microstrip feeder 10. In other words, the at least one first coupling stub and the at least one second coupling stub are not in direct contact with the microstrip feeder 10, and the microstrip feeder 10 feeds a current into the at least one first coupling stub and the at least one second coupling stub in a coupled feeding manner.

For example, as shown in FIG. 2A, a gap a1 exists between the first coupling stub 21a and the microstrip feeder 10, a gap b1 exists between the first coupling stub 21b and the microstrip feeder 10, a gap c1 exists between the first coupling stub 21c and the microstrip feeder 10, a gap d1 exists between the first coupling stub 21d and the microstrip feeder 10, and a gap e1 exists between the first coupling stub 21e and the microstrip feeder 10. A gap a2 exists between the second coupling stub 22a and the microstrip feeder 10, a gap b2 exists between the second coupling stub 22b and the microstrip feeder 10, a gap c2 exists between the second coupling stub 22c and the microstrip feeder 10, a gap d2 exists between the second coupling stub 22d and the microstrip feeder 10, and a gap e2 exists between the second coupling stub 22e and the microstrip feeder 10.

Alternatively, as shown in FIG. 2B, a gap a1 exists between the first coupling stub 21a and the microstrip feeder 10, a gap b1 exists between the first coupling stub 21b and the microstrip feeder 10, a gap c1 exists between the first coupling stub 21c and the microstrip feeder 10, a gap d1 exists between the first coupling stub 21d and the microstrip feeder 10, and a gap e1 exists between the first coupling stub 21e and the microstrip feeder 10.

Alternatively, as shown in FIG. 2C, a gap a2 exists between the second coupling stub 22a and the microstrip feeder 10, a gap b2 exists between the second coupling stub 22b and the microstrip feeder 10, a gap c2 exists between the second coupling stub 22c and the microstrip feeder 10, a gap d2 exists between the second coupling stub 22d and the microstrip feeder 10, and a gap e2 exists between the second coupling stub 22e and the microstrip feeder 10.

It should be noted that the coupling stub is specifically a type of radiator that feeds power to the microstrip feeder 10 in a coupled manner (namely, a non-contact manner). For example, the coupling stub may be an antenna radiator such as a metal patch or a metal layer.

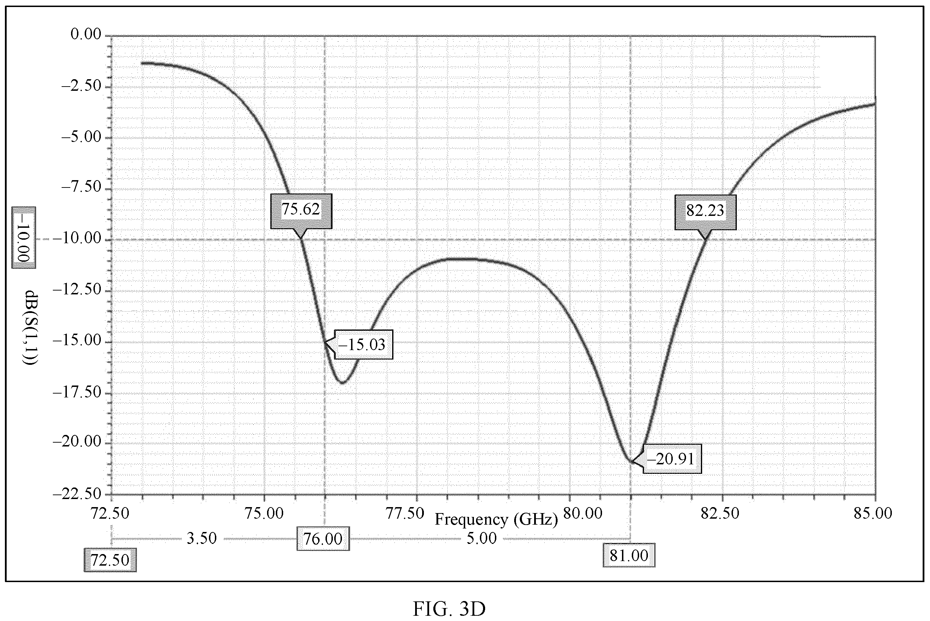

In this embodiment of this application, there is a gap between the coupling stub and the microstrip feeder 10. By using the gap, a resonant structure (namely, a resonant circuit including an inductor (L) and a capacitor (C), briefly referred to as LC) is formed between the coupling stub and the microstrip feeder 10, so that another resonance is coupled, and the antenna can generate two resonance points (in the following descriptions of FIG. 3D), to implement a larger bandwidth. Therefore, the antenna provided in this embodiment of this application increases a bandwidth, to meet a use requirement of a radar in a short range scenario, a middle range scenario, and a long range scenario, and resolve a problem that a bandwidth of an existing antenna cannot meet a use requirement of a millimeter-wave radar in a middle range scenario and a long range scenario.

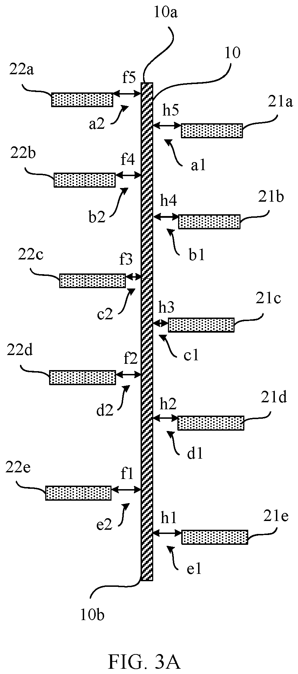

In a possible scenario and environment, the antenna provided in this embodiment of this application has been tested. As shown in FIG. 3D, a bandwidth can be expanded to 5 GHz. A gap is formed between the coupling stub and the microstrip feeder 10, so that a bandwidth can be increased.

To further implement a low sidelobe to reduce radar false alarms, in this embodiment of this application, widths of the gaps between the coupling stub and the microstrip feeder 10 satisfy a rule of first decreasing and then increasing from the first end to the second end of the microstrip feeder 10, or widths of the coupling stubs satisfy a rule of first increasing and then decreasing from the first end to the second end of the microstrip feeder 10. This implements low sidelobe effect, reduces a false alarm probability of a sidelobe level for a millimeter-wave sensor, and avoids a false alarm problem of a radar as much as possible. Therefore, the antenna provided in this embodiment of this application increases a bandwidth, implements low sidelobe effect, and resolves a false alarm problem of the millimeter-wave sensor. It should be noted herein that the rule of first decreasing and then increasing is not limited to continuous decrease and continuous increase. Widths of gaps between the microstrip feeder and coupling stubs adjacent to each other in an extension direction from the first end to the second end may be the same, provided that the widths have a tendency to first decrease and then increase on the whole. Similarly, the rule of first increasing and then decreasing is not limited to continuous increase and continuous decrease, provided that a specific tendency is satisfied. For the following rule of first decreasing and then increasing or the rule of first increasing and then decreasing, refer to the descriptions in this paragraph.

The following specifically describes in detail each implementation for implementing the low sidelobe effect.

In an implementation, the widths of the gaps between the coupling stub and the microstrip feeder 10 are changed. This implements low sidelobe effect. Specifically, a quantity of the first coupling stubs is greater than or equal to 3. For example, as shown in FIG. 2B, the first group of radiating elements 21 may include five first coupling stubs. The five first coupling stubs are respectively a first coupling stub 21a, a first coupling stub 21b, a first coupling stub 21c, a first coupling stub 21d, and a first coupling stub 21e. A gap a1 exists between the first coupling stub 21a and the microstrip feeder 10, a gap b1 exists between the first coupling stub 21b and the microstrip feeder 10, a gap c1 exists between the first coupling stub 21c and the microstrip feeder 10, a gap d1 exists between the first coupling stub 21d and the microstrip feeder 10, and a gap e1 exists between the first coupling stub 21e and the microstrip feeder 10.

To implement low sidelobe effect, the gaps between the first coupling stubs and the microstrip feeder 10 first decrease and then increase from the first end to the second end of the microstrip feeder 10. For example, as shown in FIG. 3A, a width of the gap e1 between the first coupling stub 21e and the microstrip feeder 10 is h1, a width of the gap d1 between the first coupling stub 21d and the microstrip feeder 10 is h2, a width of the gap c1 between the first coupling stub 21c and the microstrip feeder 10 is h3, a width of the gap b1 between the first coupling stub 21b and the microstrip feeder 10 is h4, a width of the gap a1 between the first coupling stub 21a and the microstrip feeder 10 is h5, and h1 > h2 > h3 < h4 < h5. In other words, in the first group of radiating elements 21, the width of the gap c1 between the first coupling stub 21c in the middle and the microstrip feeder 10 is smallest, and the width of the gap a1 between the first coupling stub 21a and the microstrip feeder 10 and the width of the gap e1 between the first coupling stub 21e and the microstrip feeder 10 at two ends are largest. In this way, in the first group of radiating elements 21, a weighted design in which a gap in the middle is small and gaps at two ends are large is formed between the first coupling stubs and the microstrip feeder 10.

The widths of the gaps between the first coupling stubs and the microstrip feeder 10 satisfy the rule of first decreasing and then increasing from the first end 10a to the second end of the microstrip feeder 10. This implements low sidelobe effect, reduces a false alarm probability of a minor lobe level for the millimeter-wave sensor, and avoids a false alarm problem of a radar as much as possible.

Alternatively, a quantity of the second coupling stubs is greater than or equal to 3. For example, as shown in FIG. 2C, the second group of radiating elements 22 may include five second coupling stubs. The five second coupling stubs are respectively a second coupling stub 22a, a second coupling stub 22b, a second coupling stub 22c, a second coupling stub 22d, and a second coupling stub 22e.

As shown in FIG. 2C, in the second group of radiating elements 22, a width of the gap e2 between the second coupling stub 22e and the microstrip feeder 10 is f1, a width of the gap d2 between the second coupling stub 22d and the microstrip feeder 10 is f2, a width of the gap c2 between the second coupling stub 22c and the microstrip feeder 10 is f3, a width of the gap b2 between the second coupling stub 22b and the microstrip feeder 10 is f4, a width of the gap a2 between the second coupling stub 22a and the microstrip feeder 10 is f5, and f1 > f2 > f3 < f4 < f5. In other words, in the second group of radiating elements 22, the width of the gap c2 between the second coupling stub 22c in the middle and the microstrip feeder 10 is smallest, and the width of the gap a2 between the second coupling stub 22a and the microstrip feeder 10 and the width of the gap e2 between the second coupling stub 22e and the microstrip feeder 10 at two ends are largest. In this way, in the second group of radiating elements 22, a weighted design in which a gap in the middle is small and gaps at two ends are large is formed between the second coupling stubs and the microstrip feeder 10.

The widths of the gaps between the second coupling stubs and the microstrip feeder 10 satisfy the rule of first decreasing and then increasing from the first end 10a to the second end 10b of the microstrip feeder 10. This implements low sidelobe effect, reduces a false alarm probability of a minor lobe level for the millimeter-wave sensor, and avoids a false alarm problem of a radar as much as possible.

Alternatively, a quantity of the first coupling stubs is greater than or equal to 3, and a quantity of the second coupling stubs is also greater than or equal to 3. For example, as shown in FIG. 3A, the first group of radiating elements 21 may include five first coupling stubs. The five first coupling stubs are respectively a first coupling stub 21a, a first coupling stub 21b, a first coupling stub 21c, a first coupling stub 21d, and a first coupling stub 21e. The second group of radiating elements 22 may include five second coupling stubs. The five second coupling stubs are respectively a second coupling stub 22a, a second coupling stub 22b, a second coupling stub 22c, a second coupling stub 22d, and a second coupling stub 22e.

The first coupling stubs and the second coupling stubs are alternately distributed along the microstrip feeder 10. For example, as shown in FIG. 3A, the five first coupling stubs and the five second coupling stubs are alternately distributed from the first end 10a to the second end 10b of the microstrip feeder 10 in a sequence of the second coupling stub 22a, the first coupling stub 21a, the second coupling stub 22b, the first coupling stub 21b, the second coupling stub 22c, the first coupling stub 21c, the second coupling stub 22d, the first coupling stub 21d, the second coupling stub 22e, and the first coupling stub 21e.

Gaps exist between the microstrip feeder 10 and both of the first coupling stubs and the second coupling stubs. For example, as shown in FIG. 3A, a gap a1 exists between the first coupling stub 21a and the microstrip feeder 10, a gap b1 exists between the first coupling stub 21b and the microstrip feeder 10, a gap c1 exists between the first coupling stub 21c and the microstrip feeder 10, a gap d1 exists between the first coupling stub 21d and the microstrip feeder 10, and a gap e1 exists between the first coupling stub 21e and the microstrip feeder 10. A gap a2 exists between the second coupling stub 22a and the microstrip feeder 10, a gap b2 exists between the second coupling stub 22b and the microstrip feeder 10, a gap c2 exists between the second coupling stub 22c and the microstrip feeder 10, a gap d2 exists between the second coupling stub 22d and the microstrip feeder 10, and a gap e2 exists between the second coupling stub 22e and the microstrip feeder 10.

The gaps between the first coupling stubs and the microstrip feeder 10 first decrease and then increase from the first end 10a to the second end 10b of the microstrip feeder 10. For example, as shown in FIG. 3A, a width of the gap e1 between the first coupling stub 21e and the microstrip feeder 10 is h1, a width of the gap d1 between the first coupling stub 21d and the microstrip feeder 10 is h2, a width of the gap c1 between the first coupling stub 21c and the microstrip feeder 10 is h3, a width of the gap b1 between the first coupling stub 21b and the microstrip feeder 10 is h4, a width of the gap a1 between the first coupling stub 21a and the microstrip feeder 10 is h5, and h1 > h2 > h3 < h4 < h5. In other words, in the first group of radiating elements 21, the width of the gap c1 between the first coupling stub 21c in the middle and the microstrip feeder 10 is smallest, and the width of the gap a1 between the first coupling stub 21a and the microstrip feeder 10 and the width of the gap e 1 between the first coupling stub 21e and the microstrip feeder 10 at two ends are largest. In this way, in the first group of radiating elements 21, a weighted design in which a gap in the middle is small and gaps at two ends are large is formed between the first coupling stubs and the microstrip feeder 10.

The gaps between the second coupling stubs and the microstrip feeder 10 first decrease and then increase from the first end 10a to the second end 10b of the microstrip feeder 10. As shown in FIG. 3A, in the second group of radiating elements 22, a width of the gap e2 between the second coupling stub 22e and the microstrip feeder 10 is f1, a width of the gap d2 between the second coupling stub 22d and the microstrip feeder 10 is f2, a width of the gap c2 between the second coupling stub 22c and the microstrip feeder 10 is f3, a width of the gap b2 between the second coupling stub 22b and the microstrip feeder 10 is f4, a width of the gap a2 between the second coupling stub 22a and the microstrip feeder 10 is f5, and f1 > f2 > f3 < f4 < f5. In other words, in the second group of radiating elements 22, the width of the gap c2 between the second coupling stub 22c in the middle and the microstrip feeder 10 is smallest, and the width of the gap a2 between the second coupling stub 22a and the microstrip feeder 10 and the width of the gap e2 between the second coupling stub 22e and the microstrip feeder 10 at two ends are largest. In this way, in the second group of radiating elements 22, a weighted design in which a gap in the middle is small and gaps at two ends are large is formed between the second coupling stubs and the microstrip feeder 10.

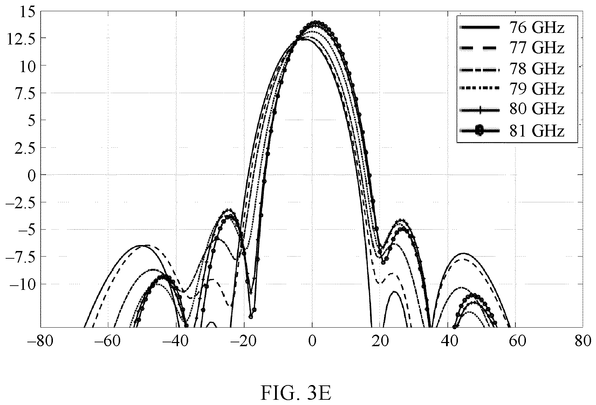

A simulation test is performed on the antenna provided in FIG. 3A. A test result is shown in FIG. 3D. A curve in FIG. 3D is a return loss curve of the antenna. It may be learned from the curve that the antenna generates two resonance points: 76 GHz and 81 GHz, so that a bandwidth can be expanded to 5 GHz, to implement a larger bandwidth. FIG. 3E is a radiation pattern of an antenna. As shown in FIG. 3E, a low sidelobe is implemented on operating frequencies of 76 GHz, 77 GHz, 78 GHz, 79 GHz, 80 GHz, and 81 GHz. In this way, a false alarm probability of a minor lobe level for the millimeter-wave sensor is reduced. In other words, false alarms are not likely to occur.

Therefore, the widths of the gaps between both of the first coupling stubs and the second coupling stubs and the microstrip feeder 10 satisfy the rule of first decreasing and then increasing from the first end 10a to the second end 10b of the microstrip feeder 10. This implements low sidelobe effect, reduces a false alarm probability of a minor lobe level for the millimeter-wave sensor, and avoids a false alarm problem of a radar as much as possible.

It should be noted that, in some examples, the first group of radiating elements 21 includes but is not limited to five first coupling stubs, and the second group of radiating elements 22 includes but is not limited to five second coupling stubs. For example, the first group of radiating elements 21 may alternatively include 10 to 20 first coupling stubs, and the second group of radiating elements 22 may alternatively include 10 to 20 second coupling stubs.

It should be noted that the quantity of the first coupling stubs in the first group of radiating elements 21 may be the same as the quantity of the second coupling stubs in the second group of radiating elements 22. Certainly, in some examples, the quantity of the first coupling stubs in the first group of radiating elements 21 may alternatively be different from the quantity of the second coupling stubs in the second group of radiating elements 22. For example, the quantity of the first coupling stubs in the first group of radiating elements 21 may be 8, and the quantity of the second coupling stubs in the second group of radiating elements 22 may be 9.

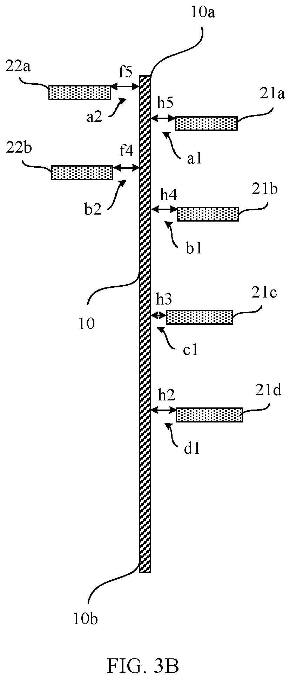

In another implementation, a sum of the quantity of the first coupling stubs and the quantity of the second coupling stubs is greater than or equal to 3. For example, as shown in FIG. 3B, the quantity of the second coupling stubs is 2, and the quantity of the first coupling stub may be 1, or may be 4 shown in FIG. 3B. In this way, the sum of the quantity of the first coupling stubs and the quantity of the second coupling stubs is 6. To implement low sidelobe effect, the first coupling stubs and the second coupling stubs are alternately distributed on two sides of the microstrip feeder 10. In addition, the widths of gaps between both of the first coupling stubs and the second coupling stubs and the microstrip feeder 10 satisfy the rule of first decreasing and then increasing from the first end 10a to the second end 10b of the microstrip feeder 10. For example, as shown in FIG. 3B, a width of the gap b2 between the second coupling stub 22b and the microstrip feeder 10 is f4, a width of the gap a2 between the second coupling stub 22a and the microstrip feeder 10 is f5, a width of the gap d1 between the first coupling stub 21d and the microstrip feeder 10 is h2, a width of the gap c1 between the first coupling stub 21c and the microstrip feeder 10 is h3, a width of the gap b1 between the first coupling stub 21b and the microstrip feeder 10 is h4, a width of the gap a1 between the first coupling stub 21a and the microstrip feeder 10 is h5, and h2 > h3 < h4 < f4 < h5 < f5.

The widths of the gaps between the microstrip feeder 10 and both of the first coupling stubs and the second coupling stubs on the two sides of the microstrip feeder 10 satisfy the rule of first decreasing and then increasing from the first end 10a to the second end 10b of the microstrip feeder 10. This implements low sidelobe effect, reduces a false alarm probability of a minor lobe level for the millimeter-wave sensor, and avoids a false alarm problem of a radar as much as possible.

In the foregoing two implementations, it should be noted that, when the widths of the gaps between the first coupling stubs and/or the second coupling stubs and the microstrip feeder 10 satisfy the rule of first decreasing and then increasing from the first end 10a to the second end 10b of the microstrip feeder 10, specifically the widths of the gaps between the first coupling stubs and/or the second coupling stubs and the microstrip feeder 10 have a change tendency to first decrease and then increase from the first end 10a to the second end 10b of the microstrip feeder 10 on the whole. For example, the widths of the gaps between the first coupling stubs and/or the second coupling stubs and the microstrip feeder 10 may have a change tendency to first sequentially decrease and then sequentially increase from the first end 10a to the second end 10b of the microstrip feeder 10, or the widths of the gaps between the first coupling stubs and/or the second coupling stubs and the microstrip feeder 10 may have a change tendency to first decrease, then be the same, and then increase from the first end 10a to the second end 10b of the microstrip feeder 10.

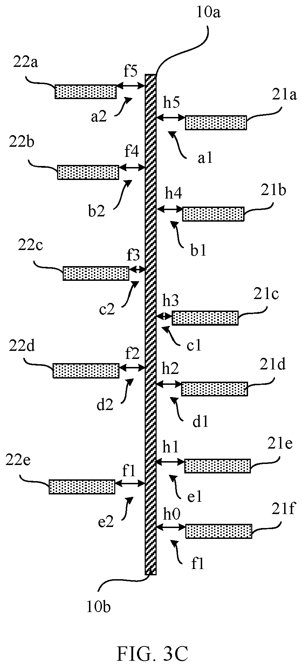

Alternatively, same widths of gaps may exist in a decreasing or increasing process. For example, as shown in FIG. 3C, h0 = h1 > h2 > h3 < h4 < h5, and f1 > f2 > f3 < f4 < f5. Alternatively, in some other examples, h0 > h1 = h2 > h3 < h4 < h5, and f1 > f2 > f3 = f4 < f5. Therefore, the widths of the gaps between both of the first coupling stubs and the second coupling stubs and the microstrip feeder 10 have a change tendency to first decrease and then increase on the whole, but is not limited to a change tendency to first sequentially decrease and then sequentially increase.

In a possible implementation, a width of a gap between the microstrip feeder 10 and any first coupling stub is greater than or equal to 0.076 mm and less than or equal to 0.9 mm. For example, h1 may be 0.8 mm, h2 may be 0.7 mm, h3 may be 0.6 mm, h4 may be 0.5 mm, and h5 may be 0.4 mm. The widths of the gaps satisfy the rule of first decreasing and then increasing from the first end 10a to the second end 10b of the microstrip feeder 10. Alternatively, a width of a gap between the microstrip feeder 10 and any second coupling stub is greater than or equal to 0.076 mm and less than or equal to 0.9 mm. For example, f1 may be 0.85 mm, f2 may be 0.75 mm, f3 may be 0.65 mm, f4 may be 0.55 mm, and f5 may be 0.45 mm. The widths of the gaps satisfy the rule of first decreasing and then increasing from the first end 10a to the second end 10b of the microstrip feeder 10. Alternatively, a width of a gap between the microstrip feeder 10 and any first coupling stub and a width of a gap between the microstrip feeder 10 and any second coupling stub are greater than or equal to 0.076 mm and less than or equal to 0.9 mm. The width of the gap between the microstrip feeder 10 and the first coupling stub and the width of the gap between the microstrip feeder 10 and the second coupling stub are greater than or equal to 0.076 mm and less than or equal to 0.9 mm. This can ensure that coupled feeding can be implemented between each coupling stub and the microstrip feeder 10, to avoid poor coupling effect caused by an excessively large gap and a resonance generation difficulty caused by an excessively small gap. It should be noted herein that values and value ranges involved in this application are approximate values. Due to impact of a manufacturing process, there may be an error within a specific range, and a person skilled in the art may consider that the error is ignored.

It should be noted that the gaps between the coupling stubs in the first group of radiating elements 21 may be equal to the gaps between the coupling stubs in the second group of radiating elements 22. For example, a size of the gap e1 may be equal to a size of the gap e2, that is, f1 = h1. A size of the gap d1 may be equal to a size of the gap d2, that is, f2 = h2. A size of the gap c1 may be equal to a size of the gap c2, that is, f3 = h3. A size of the gap b1 may be equal to a size of the gap b2, that is, f4 = h4. A size of the gap a1 may be equal to a size of the gap a2, that is, f5 = h5. Certainly, in some examples, the gaps between the coupling stubs in the first group of radiating elements 21 may alternatively be different from the gaps between the coupling stubs in the second group of radiating elements 22. For example, f1 ≠ h1, f2 ≠ h2, f3 ≠ h3, f4 ≠ h4, and f5 ≠ h5.

In a possible implementation, the first group of radiating elements 21 and the second group of radiating elements 22 include at least two groups of adjacent first coupling stubs and second coupling stubs. For example, the first group of radiating elements 21 may include a first coupling stub 21a, the second group of radiating elements 22 may include a second coupling stub 22a and a second coupling stub 22b, and the first coupling stub 21a is separately adjacent to the second coupling stub 22a and the second coupling stub 22b. In this way, the two groups of adjacent first coupling stubs and second coupling stubs are respectively one group with the first coupling stub 21a and the second coupling stub 22a and the other group with the first coupling stub 21a and the second coupling stub 22b. In addition, a distance between the first coupling stub 21a and the second coupling stub 22a is m9, a distance between the first coupling stub 21a and the second coupling stub 22b is m8, and m8 ≠ m9. This can further implement a low sidelobe.

In an optional design, a distance between the first coupling stub and the second coupling stub may be a vertical distance between a center of the first coupling stub and a center of the second coupling stub. The foregoing implementation may alternatively be understood as that vertical distances between centers of two groups of adjacent first coupling stubs and second coupling stubs are different. It should be further noted that, in specific product design and measurement, there may be a plurality of manners for determining the distance between the first coupling stub and the second coupling stub. This is not specifically limited in this application. For content related to the distance between the coupling stubs in other parts, refer to the descriptions in this paragraph.

In this embodiment of this application, the adjacent first coupling stubs and second coupling stubs specifically indicate first coupling stubs and one or two closest second coupling stubs, and may alternatively be understood as adjacent first coupling stubs and second coupling stubs in an extension direction of the microstrip feeder

In this embodiment of this application, the first group of radiating elements 21 and the second group of radiating elements 22 include but are not limited to two groups of adjacent first coupling stubs and second coupling stubs. The first group of radiating elements 21 and the second group of radiating elements 22 may include at least two groups of adjacent first coupling stubs and second coupling stubs. Optionally, when the first group of radiating elements 21 and the second group of radiating elements 22 include at least two groups of adjacent first coupling stubs and second coupling stubs, distances between adjacent first coupling stubs and second coupling stubs in any two groups included in the first group of radiating elements 21 and the second group of radiating elements 22 are different.

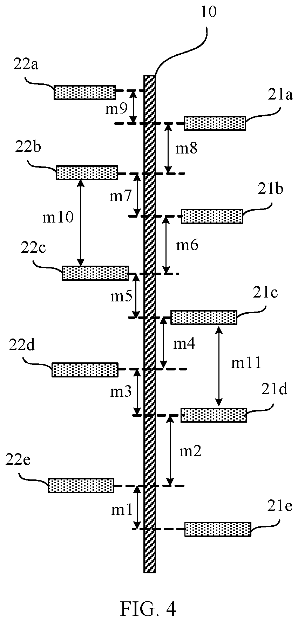

For example, as shown in FIG. 4, a distance between the second coupling stub 22a and the first coupling stub 21a is m9, a distance between the second coupling stub 22b and the first coupling stub 21a is m8, a distance between the second coupling stub 22b and the first coupling stub 21b is m7, a distance between the second coupling stub 22c and the first coupling stub 21b is m6, a distance between the second coupling stub 22c and the first coupling stub 21c is m5, a distance between the first coupling stub 21c and the second coupling stub 22d is m4, a distance between the second coupling stub 22d and the first coupling stub 21d is m3, a distance between the first coupling stub 21d and the second coupling stub 22e is m2, a distance between the second coupling stub 22e and the first coupling stub 21e is m1, and m1 ≠ m2 ≠ m3 ≠ m4 ≠ m5 ≠ m6 ≠ m7 ≠ m8 ≠ m9.

A distance between the first coupling stub and the second coupling stub that are adjacent to each other in any group included in the first group of radiating elements 21 and the second group of radiating elements 22 is greater than or equal to 0.4*λ_{g}* and less than or equal to 0.6*λ_{g}*, and *λ_{g}* is a wavelength of an electromagnetic wave transmitted in the dielectric plate 200a by using the first coupling stub or the second coupling stub, or may be understood as that *λ_{g}* is a wavelength in a dielectric material. The dielectric material is the dielectric plate 200a configured to carry the microstrip feeder 10 and the coupling stubs. In an optional design, *λ_{g}* may be 2.26 millimeters (mm), and/or the distance between the first coupling stub and the second coupling stub that are adjacent to each other in any group may be greater than or equal to 0.904 mm and less than or equal to 1.356 mm. For example, m1 = 1 mm, m2 = 1.05 mm, m2 = 1.1 mm, m4 = 1.15 mm, m5 = 1.18 mm, m6 = 1.2 mm, m7 = 1.25 mm, m8 = 1.28 mm, and m9 = 1.3 mm.

In a possible implementation, the distance between the first coupling stub and the second coupling stub that are adjacent to each other in any group included in the first group of radiating elements 21 and the second group of radiating elements 22 may be greater than or equal to 10 mm and less than or equal to 1.3 mm.

As shown in FIG. 4, a distance between two adjacent first coupling stubs in the first group of radiating elements 21 may be greater than or equal to 0.4*λ_{g}* and less than or equal to 1.2*λ_{g}*. Optionally, if *λ_{g}* is 2.26 mm, a distance m11 between two adjacent first coupling stubs in the first group of radiating elements 21 is greater than or equal to 0.904 mm and less than or equal to 2.7 mm. As shown in FIG. 4, the distance m11 between the first coupling stub 21c and the first coupling stub 21d in the first group of radiating elements 21 may be 2.0 mm, or the distance m11 between the first coupling stub 21c and the first coupling stub 21d in the first group of radiating elements 21 may be 2.4 mm.

A distance between two adjacent second coupling stubs in the second group of radiating elements 22 may be greater than or equal to 0.4*λ_{g}* and less than or equal to 1.2*λ_{g}*. Optionally, if *λ_{g}* is 2.26 mm, a distance m11 between two adjacent second coupling stubs in the second group of radiating elements 22 is greater than or equal to 0.904 mm and less than or equal to 2.7 mm. For example, a distance m10 between the second coupling stub 22b and the second coupling stub 22c in the second group of radiating elements 22 may be 1.8 mm, or a distance m 10 between the second coupling stub 22b and the second coupling stub 22c in the second group of radiating elements 22 may be 2.3 mm.

In this embodiment of this application, it should be noted that, because the first coupling stubs and the second coupling stubs are alternately distributed along the microstrip feeder 10, the distance between the two adjacent first coupling stubs or the distance between the two adjacent second coupling stubs may be greater than the distance between the first coupling stub and the second coupling stub that are adjacent to each other. For example, m11 may be greater than m4, or m10 is greater than m6.

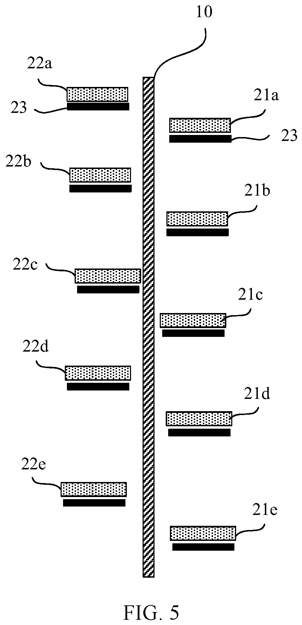

In a possible implementation, the antenna further includes a matching stub 23. At least one matching stub is disposed on at least one side of one or more first coupling stubs of the at least one first coupling stub. For example, as shown in FIG. 5, one matching stub 23 is disposed on one side of each first coupling stub. Certainly, in some examples, matching stubs 23 may alternatively be disposed on one side or two sides of some first coupling stubs. Alternatively, at least one matching stub is disposed on at least one side of one or more second coupling stubs of the at least one second coupling stub. For example, as shown in FIG. 5, one matching stub 23 is disposed on one side of each second coupling stub. Certainly, in some examples, matching stubs 23 may alternatively be disposed on one side or two sides of some second coupling stubs. Alternatively, at least one matching stub 23 may be disposed on at least one side of one or more first coupling stubs of the at least one first coupling stub and at least one side of one or more second coupling stubs of the at least one second coupling stub.

A gap exists between the matching stub and the microstrip feeder 10 and between the matching stub and one or more first coupling stubs and/or one or more second coupling stubs. In this way, coupling is implemented between the matching stub 23 and the first coupling stubs and/or the second coupling stubs, so that a bandwidth covered by the antenna is larger.

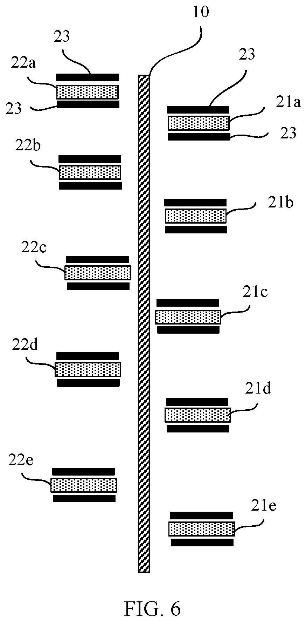

In another implementation, as shown in FIG. 6, matching stubs 23 are disposed on two sides of the first coupling stub and the second coupling stub. Gaps exist between both of the first coupling stub and the second coupling stub and the matching stubs 23 on the two sides. A gap exists between the matching stub 23 and the microstrip feeder 10. The matching stubs 23 are disposed on the two sides of the coupling stub, so that radiation performance of the antenna is improved, and a bandwidth covered by the antenna is larger It should be noted that the matching stub 23 specifically refers to a matching radiator for increasing a bandwidth of the antenna.

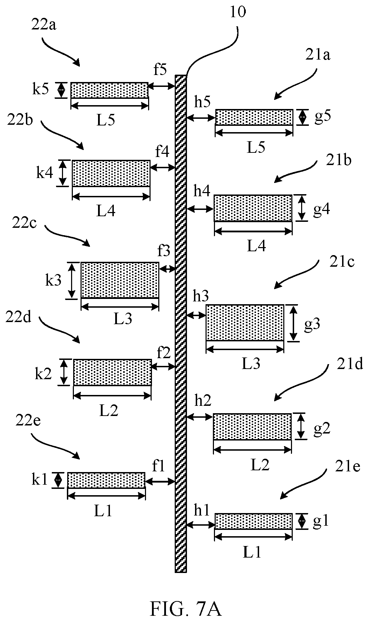

In a possible implementation, on the basis of changing the width of the gap between the coupling stub and the microstrip feeder 10, the width of the coupling stub may be changed, to further implement low sidelobe effect. In this embodiment of this application, the quantity of the first coupling stubs is greater than or equal to 3, the quantity of the second coupling stubs is greater than or equal to 3, the widths of the at least one second coupling stub satisfy the rule of first increasing and then decreasing from the first end 10a to the second end 10b of the microstrip feeder 10, and the widths of the at least one first coupling stub satisfy the rule of first increasing and then decreasing from the first end 10a to the second end 10b of the microstrip feeder 10. For example, as shown in FIG. 7A, widths of the first coupling stub 21a, the first coupling stub 21b, the first coupling stub 21c, the first coupling stub 21d, and the first coupling stub 21e are respectively g5, g4, g3, g2, and g1, and g5 < g4 < g3 > g2 > g1. In the first group of radiating elements 21, a width of the first coupling stub 21c in the middle is largest, and widths of the first coupling stub 21a and the first coupling stub 21e at two ends are smallest.

The widths of the second coupling stub 22a, the second coupling stub 22b, the second coupling stub 22c, the second coupling stub 22d, and the second coupling stub 22e are respectively k5, k4, k3, k2, and k1, and k5 < k4 < k3 > k2 > k1. In other words, in the second group of radiating elements 22, a width of the second coupling stub 22c in the middle is largest, and widths of the second coupling stub 22a and the second coupling stub 22e at two ends are smallest.

In this embodiment of this application, the widths of the first coupling stubs and the second coupling stubs satisfy the rule of first increasing and then decreasing from the first end 10a to the second end 10b of the microstrip feeder 10. This further implements low sidelobe effect, reduces a false alarm probability of a minor lobe level for the millimeter-wave sensor, and avoids a false alarm problem of a radar as much as possible.

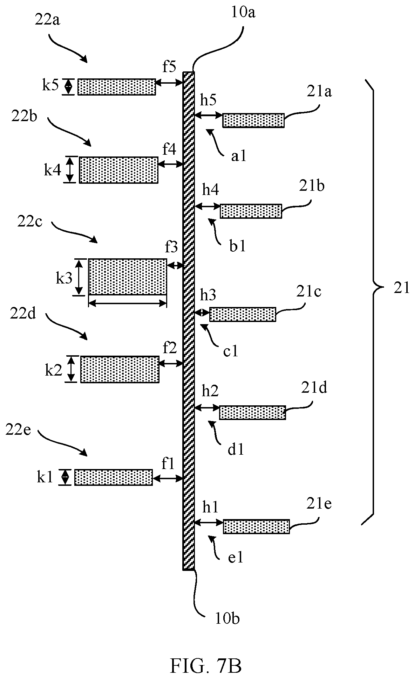

Alternatively, in some examples, the quantity of the second coupling stubs is greater than or equal to 3, and the widths of the at least one second coupling stub satisfy the rule of first increasing and then decreasing from the first end 10a to the second end 10b of the microstrip feeder 10. For example, as shown in FIG. 7B, widths of the second coupling stub 22a, the second coupling stub 22b, the second coupling stub 22c, the second coupling stub 22d, and the second coupling stub 22e are respectively k5, k4, k3, k2, and k1, and k5 < k4 < k3 > k2 > k1. The widths of the first coupling stubs in the first group of radiating elements 21 may be the same.

Alternatively, in some examples, the quantity of the first coupling stubs is greater than or equal to 3, and the widths of the at least one first coupling stub satisfy the rule of first increasing and then decreasing from the first end 10a to the second end 10b of the microstrip feeder 10. Reference may be made to a width change (for example, g5 < g4 < g3 > g2 > g1) of the first coupling stubs in the first group of radiating elements 21 in FIG. 7A.

It should be noted that the widths of the at least one second coupling stub and/or the widths of the at least one first coupling stub satisfy the rule of first increasing and then decreasing from the first end 10a to the second end 10b of the microstrip feeder 10, specifically the widths of the at least one second coupling stub and/or the widths of the at least one first coupling stub satisfy the rule of first increasing and then decreasing from the first end 10a to the second end 10b of the microstrip feeder 10. It does not mean that the widths of the at least one second coupling stub and/or the widths of the at least one first coupling stub satisfy the rule of first sequentially increasing and then sequentially decreasing from the first end 10a to the second end 10b of the microstrip feeder 10. For example, same widths of two adjacent coupling stubs may exist when the widths of the at least one second coupling stub and/or the widths of the at least one first coupling stub decrease or increase from the first end 10a to the second end 10b of the microstrip feeder 10.

In a possible implementation, the widths of the at least one first coupling stub and the at least one second coupling stub are greater than or equal to 0.076 mm and less than or equal to 0.9 mm, or widths of any first coupling stub and any second coupling stub are greater than or equal to 0.076 mm and less than or equal to 0.9 mm. For example, the widths of the first coupling stub 21a, the first coupling stub 21b, the first coupling stub 21c, the first coupling stub 21d, and the first coupling stub 21e are respectively g5, g4, g3, g2, and g1, g5 = 0.2, g4 = 0.4, g3 = 0.6, g2 = 0.4, and g1 = 0.2. The widths of the second coupling stub 22a, the second coupling stub 22b, the second coupling stub 22c, the second coupling stub 22d, and the second coupling stub 22e are respectively k5, k4, k3, k2, and k1, k5 = 0.1, k4 = 0.5, k3 = 0.9, g2 = 0.5, and k1 = 0.1.

In a possible implementation, a length of the at least one first coupling stub and a length of the at least one second coupling stub are greater than or equal to 0.4*λ_{g}* and less than or equal to 0.6*λ_{g}*, or a length of any first coupling stub and a length of any second coupling stub are greater than or equal to 0.4*λ_{g}* and less than or equal to 0.6*λ_{g}*, and *λ_{g}* is a wavelength of an electromagnetic wave transmitted in the dielectric plate 200a by using the first coupling stub or the second coupling stub, or may be understood as that *λ_{g}* is a wavelength in a dielectric material. The dielectric material is the dielectric plate 200a configured to carry the microstrip feeder 10 and the coupling stubs. In an optional design, *λ_{g}* may be 2.26 millimeters (mm), and/or a length of the at least one first coupling stub and a length of the at least one second coupling stub, or a length of any first coupling stub and a length of any second coupling stub are greater than or equal to 0.904 mm and less than or equal to 1.356 mm.

In a possible implementation, the length of the first coupling stub and the length of the second coupling stub may be the same, or the length of the at least one first coupling stub and the length of the at least one second coupling stub are the same. The length of the first coupling stub and the length of the second coupling stub may be greater than or equal to 1.0 mm and less than or equal to 1.2 mm. For example, as shown in FIG. 7A, lengths of the first coupling stub 21a, the first coupling stub 21b, the first coupling stub 21c, the first coupling stub 21d, and the first coupling stub 21e are respectively L5, L4, L3, L2, and L1, L5 = L4 = L3 = L2 = L1 = 1.1 mm, or LS = L4 = L3 = L2 = L1 = 1.2 mm.

Lengths of the second coupling stub 22a, the second coupling stub 22b, the second coupling stub 22c, the second coupling stub 22d, and the second coupling stub 22e are respectively L5, L4, L3, L2, and L1, L5 = L4 = L3 = L2 = L1 = 1.0 mm, or L5 = L4 = L3 = L2 = L1 = 1.15 mm.

Certainly, in some examples, the length of the first coupling stub and the length of the second coupling stub may be different. For example, lengths of the first coupling stubs may also first increase and then decrease from the first end 10a to the second end 10b of the microstrip feeder 10. Lengths of the second coupling stubs may also first increase and then decrease from the first end 10a to the second end 10b of the microstrip feeder 10.

In a possible implementation, the at least one first coupling stub or the at least one second coupling stub or both are rectangular or trapezoidal patches, or the any first coupling stub or the any second coupling stub or both may be rectangular or trapezoidal patches.

Certainly, in some other examples, shapes of the first coupling stub and the second coupling stub include but are not limited to rectangles or trapezoids, for example, may alternatively be polygonal shapes or circle shapes. The rectangular patch may be specifically a metal patch, for example, a copper sheet or an aluminum sheet.

### Embodiment 2

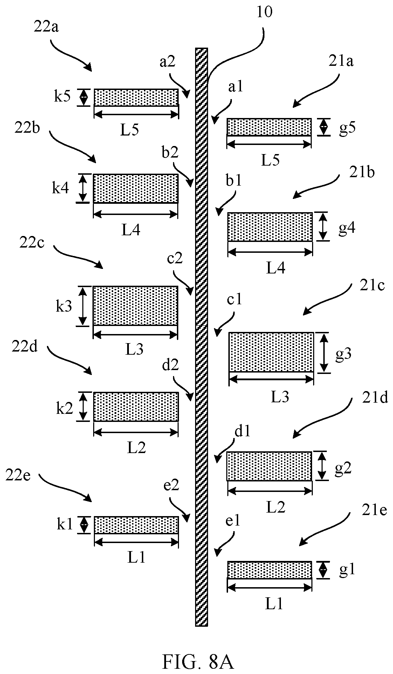

In this embodiment of this application, widths of first coupling stubs and/or second coupling stubs are changed, to implement a low sidelobe. For example, gaps between at least one first coupling stub and/or at least one second coupling stub and a microstrip feeder 10 are the same. For example, as shown in FIG. 8A, gaps a1, b1, c1, d1, and e1 between five first coupling stubs (namely, a first coupling stub 21a, a first coupling stub 21b, a first coupling stub 21c, a first coupling stub 21d, and a first coupling stub 21e) and the microstrip feeder 10 may be the same. Gaps a2, b2, c2, d2, and e2 between five second coupling stubs (namely, a second coupling stub 22a, a second coupling stub 22b, a second coupling stub 22c, a second coupling stub 22d, and a second coupling stub 22e) and the microstrip feeder 10 may be the same.

To implement low sidelobe effect, a quantity of the first coupling stubs may be greater than or equal to 3, and a quantity of the second coupling stubs may be greater than or equal to 3. In addition, widths of the at least one first coupling stub satisfy a rule of first increasing and then decreasing from a first end 10a to a second end 10b of the microstrip feeder 10, and widths of the at least one second coupling stub satisfy the rule of first increasing and then decreasing from the first end 10a to the second end 10b of the microstrip feeder 10.

For example, as shown in FIG. 8A, widths of the first coupling stub 21a, the first coupling stub 21b, the first coupling stub 21c, the first coupling stub 21d, and the first coupling stub 21e are respectively g5, g4, g3, g2, and g1, and g5 < g4 < g3 > g2 > g1. In a first group of radiating elements 21, a width of the first coupling stub 21c in the middle is largest, and widths of the first coupling stub 21a and the first coupling stub 21e at two ends are smallest.

Widths of the second coupling stub 22a, the second coupling stub 22b, the second coupling stub 22c, the second coupling stub 22d, and the second coupling stub 22e are respectively k5, k4, k3, k2, and k1, and k5 < k4 < k3 > k2 > k1. In other words, in a second group of radiating elements 22, a width of the second coupling stub 22c in the middle is largest, and widths of the second coupling stub 22a and the second coupling stub 22e at two ends are smallest.

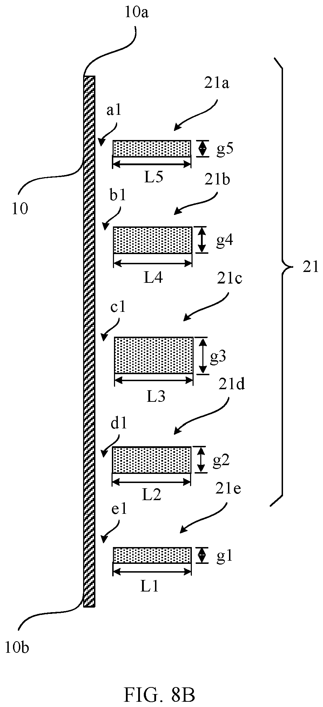

Alternatively, a quantity of the first coupling stubs may be greater than or equal to 3, and widths of the at least one first coupling stub satisfy a rule of first increasing and then decreasing from a first end 10a to a second end 10b of the microstrip feeder 10. As shown in FIG. 8B, widths of the first coupling stub 21a, the first coupling stub 21b, the first coupling stub 21c, the first coupling stub 21d, and the first coupling stub 21e are respectively g5, g4, g3, g2, and g1, and g5 < g4 < g3 > g2 > g1. In a first group of radiating elements 21, a width of the first coupling stub 21c in the middle is largest, and widths of the first coupling stub 21a and the first coupling stub 21e at two ends are smallest.

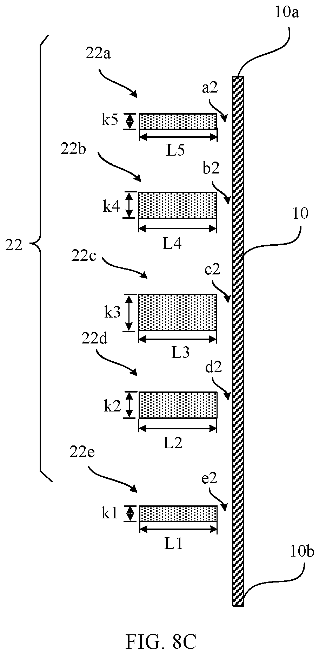

Alternatively, a quantity of the second coupling stubs may be greater than or equal to 3, and widths of the at least one second coupling stub satisfy a rule of first increasing and then decreasing from a first end 10a to a second end 10b of the microstrip feeder 10. As shown in FIG. 8C, widths of the second coupling stub 22a, the second coupling stub 22b, the second coupling stub 22c, the second coupling stub 22d, and the second coupling stub 22e are respectively k5, k4, k3, k2, and k1, and k5 < k4 < k3 > k2 > k1.

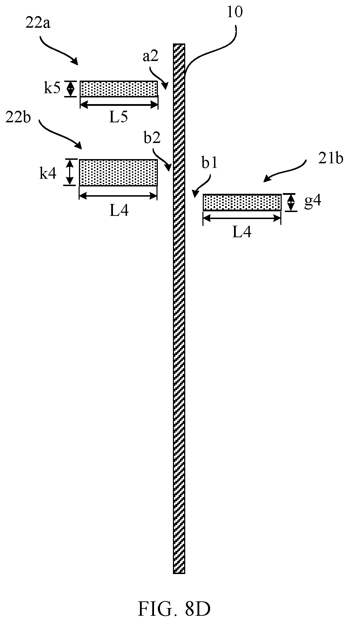

Alternatively, in a possible implementation, a sum of a quantity of the at least one first coupling stub and a quantity of the at least one second coupling stub is greater than or equal to 3, and widths of the at least one first coupling stub and the at least one second coupling stub satisfy a rule of first increasing and then decreasing from a first end 10a to a second end 10b of the microstrip feeder 10. For example, as shown in FIG. 8D, the first coupling stub 21b, the second coupling stub 22a, and the second coupling stub 22b are disposed on two sides of the microstrip feeder 10, widths of the first coupling stub 21b, the second coupling stub 22a, and the second coupling stub 22b are respectively g4, k5, and k4, and the widths of the three coupling stubs first increase and then decrease from the first end 10a (for example, the top end) to the second end 10b (for example, the bottom end) of the microstrip feeder 10, that is, k5 < k4 > g4.

In this embodiment of this application, the gaps exist between both of the first coupling stubs and the second coupling stubs and the microstrip feeder 10. In this way, a resonant structure (namely, LC) is formed between both of the first coupling stubs and the second coupling stubs and the microstrip feeder 10, so that the antenna generates another resonance. In this way, the antenna can generate two resonance points, to implement a larger bandwidth and increase a range resolution of a millimeter-wave radar. The widths of the first coupling stubs and the second coupling stubs first increase and then decrease from the first end 10a to the second end 10b of the microstrip feeder 10. This implements low sidelobe effect, reduces a false alarm probability of a minor lobe level for a millimeter-wave sensor, and avoid a false alarm problem of the radar as much as possible.

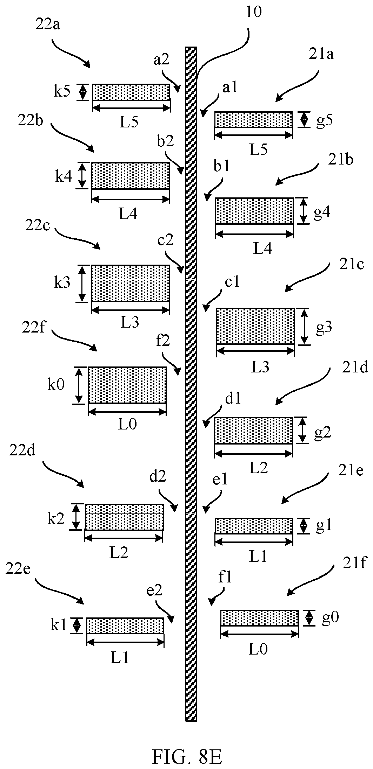

In a possible implementation, when the widths of the at least one second coupling stub and/or the widths of the at least one first coupling stub satisfy the rule of first increasing and then decreasing from the first end 10a to the second end 10b of the microstrip feeder 10, specifically the widths of the at least one second coupling stub and/or the widths of the at least one first coupling stub have a change tendency to first increase and then decrease from the first end 10a to the second end 10b of the microstrip feeder 10 on the whole. For example, as shown in FIG. 8E, k5 < k4 < k3 = k0 > k2 > k1, and g5 < g4 < g3 > g2 > g1 = g0. Therefore, same widths of adjacent coupling stubs may exist when the widths of the at least one second coupling stub and/or the widths of the at least one first coupling stub first increase and then decrease from the first end 10a to the second end 10b of the microstrip feeder 10. However, the coupling stubs have a change tendency to first increase and then decrease from the first end 10a to the second end 10b of the microstrip feeder 10 on the whole.

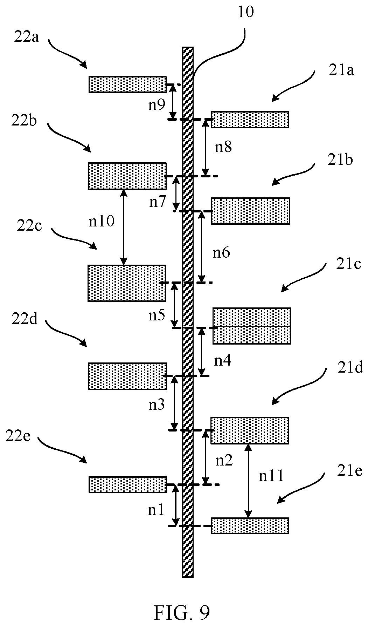

In a possible implementation, the first group of radiating elements 21 and the second group of radiating elements 22 include at least two groups of adjacent first coupling stubs and second coupling stubs. For example, as shown in FIG. 9, the first group of radiating elements 21 may include a first coupling stub 21a, and the second group of radiating elements 22 may include a second coupling stub 22a and a second coupling stub 22b. In this way, the two groups of adjacent first coupling stubs and second coupling stubs are respectively one group with the first coupling stub 21a and the second coupling stub 22a and the other adj acent group with the first coupling stub 21a and the second coupling stub 22b. In addition, a distance between the first coupling stub 21a and the second coupling stub 22a is n9, a distance between the first coupling stub 21a and the second coupling stub 22b is n8, and n8 ≠ n9. This can further implement a low sidelobe. Optionally, the distance may be a vertical distance between centers of two coupling stubs.

In this embodiment of this application, the first group of radiating elements 21 and the second group of radiating elements 22 include but are not limited to two groups of adjacent first coupling stubs and second coupling stubs. The first group of radiating elements 21 and the second group of radiating elements 22 may include at least two groups of adjacent first coupling stubs and second coupling stubs. When the first group of radiating elements 21 and the second group of radiating elements 22 include at least two groups of adjacent first coupling stubs and second coupling stubs, distances between adjacent first coupling stubs and second coupling stubs in any two groups included in the first group of radiating elements 21 and the second group of radiating elements 22 are different.

For example, as shown in FIG. 9, a distance between the second coupling stub 22a and the first coupling stub 21a is n9, a distance between the second coupling stub 22b and the first coupling stub 21a is n8, a distance between the second coupling stub 22b and the first coupling stub 21b is n7, a distance between the second coupling stub 22c and the first coupling stub 21b is n6, a distance between the second coupling stub 22c and the first coupling stub 21c is n5, a distance between the first coupling stub 21c and the second coupling stub 22d is n4, a distance between the second coupling stub 22d and the first coupling stub 21d is n3, a distance between the first coupling stub 21d and the second coupling stub 22e is n2, a distance between the second coupling stub 22e and the first coupling stub 21e is n1, and n1 ≠ n2 ≠ n3 ≠ n4 ≠ n5 ≠ n6 ≠ n7 ≠ n8 ≠ n9.

A distance between the first coupling stub and the second coupling stub that are adjacent to each other in any group included in the first group of radiating elements 21 and the second group of radiating elements 22 is greater than or equal to 0.4*λ_{g}* and less than or equal to 0.6*λ_{g}*, and *λ_{g}* is a wavelength of an electromagnetic wave transmitted in a dielectric plate 200a by using the first coupling stub or the second coupling stub, or may be understood as that *λ_{g}* is a wavelength in a dielectric material. The dielectric material is the dielectric plate 200a configured to carry the microstrip feeder 10 and the coupling stubs. In an optional design, *λ_{g}* may be 2.26 millimeters (mm), and/or the distance between the first coupling stub and the second coupling stub that are adjacent to each other in any group may be greater than or equal to 0.904 mm and less than or equal to 1.356 mm. For example, n1 = 1 mm, n2 = 1.05 mm, n2 = 1.1 mm, n4 = 1.15 mm, n5 = 1.18 mm, n6 = 1.2 mm, n7 = 1.25 mm, n8 = 1.28 mm, and n9 = 1.3 mm.

In a possible implementation, the distance between the first coupling stub and the second coupling stub that are adjacent to each other in any group included in the first group of radiating elements 21 and the second group of radiating elements 22 may be greater than or equal to 10 mm and less than or equal to 1.3 mm.

In a possible implementation, as shown in FIG. 9, a distance n11 between two adjacent first coupling stubs (for example, the first coupling stub 21e and the first coupling stub 21d) in the first group of radiating elements 21 may be greater than or equal to 0.4*λ_{g}* and less than or equal to 1.2*λ_{g}*. Optionally, if *λ_{g}* is 2.26 mm, a distance m11 between two adjacent first coupling stubs in the first group of radiating elements 21 is greater than or equal to 0.904 mm and less than or equal to 2.7 mm. For example, the distance n11 between the first coupling stub 21c and the first coupling stub 21d in the first group of radiating elements 21 may be 2.5 mm, or the distance n11 between the first coupling stub 21c and the first coupling stub 21d in the first group of radiating elements 21 may be 2.3 mm.

A distance n10 between two adjacent second coupling stubs (for example, the second coupling stub 22b and the second coupling stub 22c) in the second group of radiating elements 22 may be greater than or equal to 0.4*λ_{g}* and less than or equal to 1.2*λ_{g}*. Optionally, if *λ_{g}* is 2.26 mm, the distance between two adjacent second coupling stubs in the second group of radiating elements 22 is greater than or equal to 0.904 mm and less than or equal to 2.7 mm. For example, the distance n10 between the second coupling stub 22b and the second coupling stub 22c in the second group of radiating elements 22 may be 2.26 mm, or the distance n10 between the second coupling stub 22b and the second coupling stub 22c in the second group of radiating elements 22 may be 2.52 mm.

In this embodiment of this application, because the first coupling stubs and the second coupling stubs are alternately distributed along the microstrip feeder 10, the distance between the two adjacent first coupling stubs or the distance between the two adjacent second coupling stubs may be greater than the distance between the first coupling stub and the second coupling stub that are adjacent to each other. For example, n11 may be greater than n2, or n10 is greater than n6.

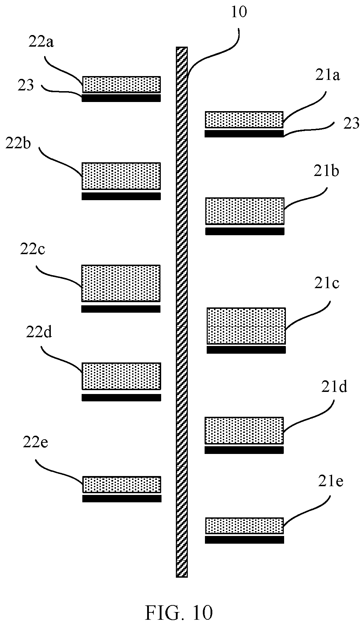

In a possible implementation, the antenna further includes a matching stub 23. At least one matching stub is disposed on at least one side of one or more first coupling stubs of the at least one first coupling stub. For example, as shown in FIG. 5, one matching stub 23 is disposed on one side of each first coupling stub. Certainly, in some examples, matching stubs 23 may alternatively be disposed on one side or two sides of some first coupling stubs. Alternatively, at least one matching stub is disposed on at least one side of one or more second coupling stubs of the at least one second coupling stub. For example, as shown in FIG. 10, one matching stub 23 is disposed on one side of each second coupling stub. Certainly, in some examples, matching stubs 23 may alternatively be disposed on one side or two sides of some second coupling stubs. Alternatively, at least one matching stub 23 may be disposed on at least one side of one or more first coupling stubs of the at least one first coupling stub and at least one side of one or more second coupling stubs of the at least one second coupling stub.

A gap exists between the matching stub and the microstrip feeder 10 and between the matching stub and one or more first coupling stubs and/or one or more second coupling stubs. In this way, coupling is implemented between the matching stub 23 and the first coupling stubs and/or the second coupling stubs, so that a bandwidth covered by the antenna is larger.

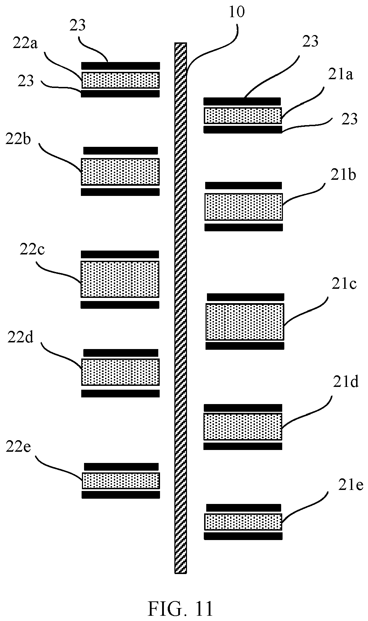

In another implementation, as shown in FIG. 11, matching stubs 23 are disposed on two sides of the first coupling stub and the second coupling stub. Gaps exist between both of the first coupling stub and the second coupling stub and the matching stubs 23 on the two sides. A gap exists between the matching stub 23 and the microstrip feeder 10. The matching stubs 23 are disposed on the two sides of the coupling stub, so that radiation performance of the antenna is improved, and a bandwidth covered by the antenna is larger

This application further provides a method for preparing an antenna provided in the foregoing embodiment. The method includes the following steps:

Step (a): Form at least one microstrip feeder 10 on one surface of a dielectric plate 200a. For example, as shown in FIG. 12A, one microstrip feeder 10 is formed on a first surface 210 of the dielectric plate 200a. The microstrip feeder 10 may be disposed extending from one end (for example, the upper end in FIG. 12A) to the other end (for example, the lower end in FIG. 12A) of the dielectric plate 200a.

Step (b): Form a first group of radiating elements 21 on a first side of the microstrip feeder 10 and/or form a second group of radiating elements 22 on a second side of the microstrip feeder 10. The first group of radiating elements 21 includes at least one first coupling stub. The second group of radiating elements 22 includes at least one second coupling stub. For example, as shown in FIG. 12A, the first group of radiating elements 21 is formed on the first side of the microstrip feeder 10, and the second group of radiating elements 22 is formed on the second side of the microstrip feeder 10. Certainly, in some examples, the first group of radiating elements 21 may be formed on the first side of the microstrip feeder 10 (as shown in FIG. 2B), or the second group of radiating elements 22 may be formed on the second side of the microstrip feeder 10 (as shown in FIG. 2C).

A gap is formed between the at least one first coupling stub and/or the at least one second coupling stub and the microstrip feeder 10. For example, a gap is formed between the at least one first coupling stub and the microstrip feeder 10, a gap is formed between the at least one second coupling stub and the microstrip feeder 10, or gaps are formed between both of the at least one first coupling stub and the at least one second coupling stub and the microstrip feeder 10.

As shown in FIG. 12A, the first group of radiating elements 21 may include a first coupling stub 21a, a first coupling stub 21b, a first coupling stub 21c, a first coupling stub 21d, and a first coupling stub 21e. The second group of radiating elements 22 may include a second coupling stub 22a, a second coupling stub 22b, a second coupling stub 22c, a second coupling stub 22d, and a second coupling stub 22e. Gaps exist between the microstrip feeder 10 and each of the first coupling stub 21a, the first coupling stub 21b, the first coupling stub 21c, the first coupling stub 21d, and the first coupling stub 21e. Gaps exist between the microstrip feeder 10 and each of the second coupling stub 22a, the second coupling stub 22b, the second coupling stub 22c, the second coupling stub 22d, and the second coupling stub 22e. Alternatively, in some examples,

The gap exists between the at least one first coupling stub and/or the at least one second coupling stub and the microstrip feeder 10. In this way, a resonant structure (namely, LC) is formed between both of the first coupling stubs and the second coupling stubs and the microstrip feeder 10, so that an antenna generates another resonance. In this way, the antenna can generate two resonance points, to implement a larger bandwidth and increase a range resolution of a millimeter-wave radar.

In this embodiment of this application, the dielectric plate 200a may be a printed circuit board (PCB). A dielectric constant of the dielectric plate 200a may be greater than or equal to 2 and less than or equal to 4. A thickness of the dielectric plate 200a may be 5 Mil (Mil).

In another possible implementation, before or after the microstrip feeder 10 and at least one group of radiating elements are formed on the first surface 210 of the dielectric plate 200a, the method further includes: A metal ground layer 300 is disposed on the other surface of the dielectric plate 200a. For example, as shown in FIG. 12B, the metal ground layer 300 is formed on a second surface 220 of the dielectric plate 200a. Each coupling stub may be electrically connected to the metal ground layer 300 through a via hole.

The metal ground layer 300 may completely or partially cover the second surface 220 of the dielectric plate 200a.

The metal ground layer 300 is specifically a metal layer made of a metal material.

It should be noted that the antenna prepared by using the preparation method provided in this application is the antenna provided in Embodiment 1 or Embodiment 2. Therefore, in the method for preparing an antenna, for change rules of widths, lengths, and gaps of the microstrip feeder 10, the first coupling stubs, and the second coupling stubs in the antenna and changes of other parameters or structures, refer to the descriptions in Embodiment 1 and Embodiment 2. Details are not described herein again.

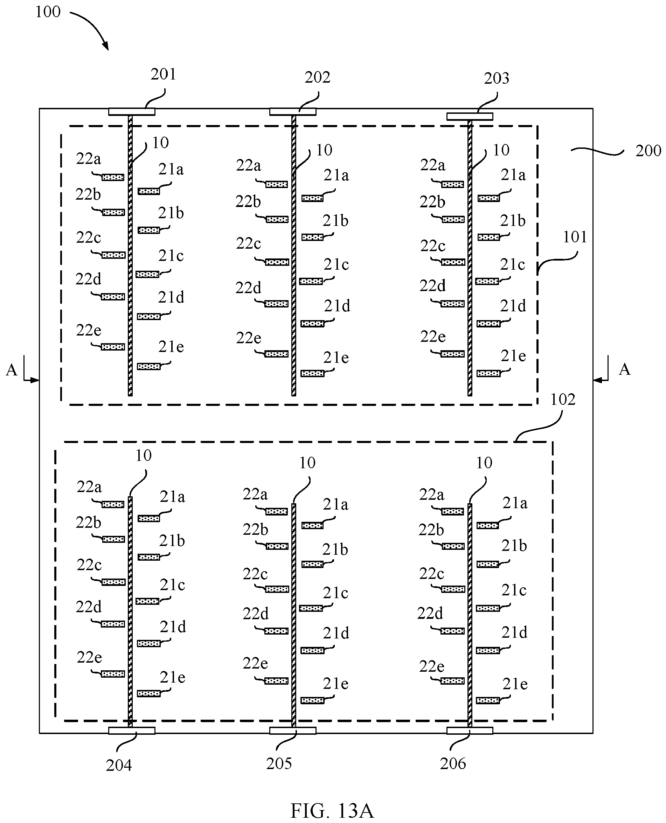

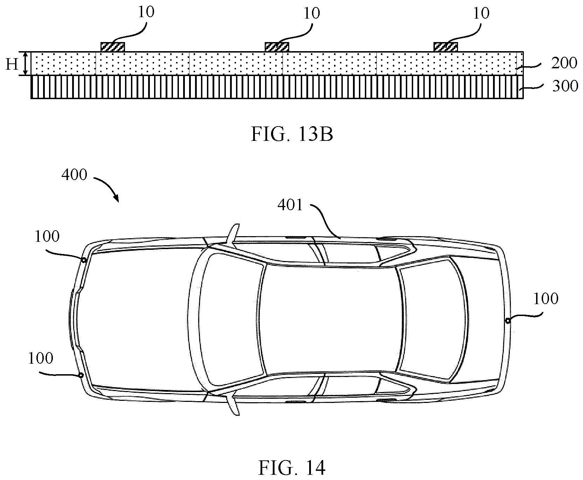

This application further provides a millimeter-wave sensor 100. As shown in FIG. 13A, the millimeter-wave sensor 100 includes at least a circuit board 200, a metal ground layer 300 located on one surface of the circuit board 200, and at least one antenna array located on the other surface of the circuit board 200. One or more antenna arrays in the at least one antenna array include at least one antenna in any one of the foregoing embodiments. For example, each antenna array may include one antenna (as shown in FIG. 13A), or each antenna array may include two antennas. As shown in FIG. 13B, the metal ground layer 300 is located on a back surface (namely, the downward surface in FIG. 13B) of the circuit board 200. The antenna array is located on a front surface (namely, the upward surface in FIG. 13A) of the circuit board 200. Each microstrip feeder 10 may be electrically connected to a feed in a radio frequency module through a feed point (for example, a feed point 201, a feed point 202, a feed point 203, a feed point 204, a feed point 205, or a feed point 206). Specifically, the feed point is electrically connected to the feed through a feeder. It should be noted that the feed is a signal source in the radio frequency module.

In a possible implementation, as shown in FIG. 13A, the at least one antenna array includes at least one transmit antenna array 101 and at least one receive antenna array 102. Any transmit antenna array and any receive antenna array include at least one antenna. For example, as shown in FIG. 13A, the transmit antenna array 101 and the receive antenna array 102 are disposed on the circuit board 200 in a spaced manner. Each transmit antenna array 101 and each receive antenna array 102 may include at least one antenna in any one of the foregoing embodiments. In addition, the microstrip feeder 10 of the antenna is electrically connected to the feed of the circuit board 200. The microstrip feeder 10, the first coupling stubs, and the second coupling stubs of the antenna are disposed on one surface of the circuit board 200. Therefore, in this embodiment of this application, the circuit board 200 may be the dielectric plate 200a in Embodiment 1, Embodiment 2, and Embodiment 3.

In a possible implementation, the circuit board 200 may be a high-frequency circuit board. The high-frequency circuit board is a special circuit board with a high electromagnetic frequency. Generally, the high frequency may be defined as a frequency above 1 GHz. The circuit board has high requirements on physical performance, precision, and technical parameters, and is often used in a field of automobile anti-collision systems, satellite systems, or radio systems. In this embodiment of this application, a thickness H of the circuit board 200 may be 5 mil. In other words, the thickness H of the circuit board 200 may be 0.127 mm.

In a possible implementation, the dielectric constant of the circuit board 200 may be greater than or equal to 2 and less than or equal to 4. For example, the dielectric constant of the circuit board 200 may be 3 or 2.5.

It should be noted that the antenna in this embodiment of this application may be the antenna in any one of Embodiment 1 and Embodiment 2. Therefore, for a structure of the antenna, refer to content in Embodiment 1 and Embodiment 2. The structure of the antenna is not described in detail in this embodiment of this application.

The millimeter-wave sensor 100 provided in this embodiment of this application includes the antenna in any one of the foregoing embodiments, to implement a larger bandwidth, increase a range resolution of a millimeter-wave radar, and meet a requirement for implementing a 5 GHz bandwidth with a long range resolution. In addition, this implements low sidelobe effect, reduces a false alarm probability of a minor lobe level for the millimeter-wave sensor 100, and avoids a false alarm problem of the millimeter-wave sensor 100 as much as possible. Therefore, when being used in a terminal, the millimeter-wave sensor 100 can improve an advanced driving assistance system (Advanced Driving Assistance System, ADAS) capability of the terminal in self-driving or assisted driving. The millimeter-wave sensor 100 may be used in the internet of vehicles, for example, vehicle-to-everything (Vehicle-to-Everything, V2X), long term evolution-vehicle (Long Term Evolution-Vehicle, LTE-V), and vehicle-to-vehicle (Vehicle-to-Vehicle).

This application further provides a terminal 400. The terminal 400 may be a fixed or mobile terminal with a sensor, for example, a vehicle, an unmanned aerial vehicle, a robot, a smart home device, or a smart manufacturing device.

In this embodiment of this application, an example in which the terminal 400 is a vehicle is specifically used for description. The vehicle may be an electric car/electric vehicle (Electric Vehicle, EV for short) or an electric serving trolley, or may be an electric express car. Alternatively, the terminal 400 may be a pure electric vehicle (Pure Electric Vehicle/Battery Electric Vehicle, PEV/BEV for short), a hybrid electric vehicle (Hybrid Electric Vehicle, HEV for short), a range extended electric vehicle (Range Extended Electric Vehicle, REEV for short), a plug-in hybrid electric vehicle (Plug-in Hybrid Electric Vehicle, PHEV for short), and a new energy vehicle (New Energy Vehicle).

As shown in FIG. 14, the terminal 400 includes at least a body 401 and at least one sensor disposed on the body 401. The at least one sensor includes at least one millimeter-wave sensor 100 in any one of the foregoing embodiments. For example, in FIG. 14, three sensors are disposed on the body 401. The three sensors may all be the millimeter-wave sensor 100 in the foregoing embodiment, or one or two of the three sensors may be the millimeter-wave sensor 100 in the foregoing embodiment. In this embodiment of this application, an example in which all the three sensors are the millimeter-wave sensor 100 is specifically used for description.

As shown in FIG. 14, two millimeter-wave sensors 100 are disposed on a front bumper of the body 401, and one millimeter-wave sensor 100 is disposed on a rear bumper of the body 401. It should be noted that a quantity of millimeter-wave sensors 100 includes but is not limited to three. For example, the millimeter-wave sensors 100 may be separately disposed on two sides of the body 401.

It should be noted that for a structure of the body 401, refer to a structure of an existing vehicle. Details are not described again in this embodiment of this application.

In this embodiment of this application, the millimeter-wave sensor 100 is a millimeter-wave radar, a millimeter-wave distance sensor, or a millimeter-wave ambient light sensor.

The terminal provided in this embodiment of this application includes the millimeter-wave sensor 100, to implement a larger bandwidth, increase a range resolution of a millimeter-wave radar, meet a requirement for implementing a 5 GHz bandwidth with a long range resolution, and ensure accurate detection of a vehicle 40 in a long range scenario and a middle range scenario. In addition, this implements low sidelobe effect, reduces a false alarm probability of a minor lobe level for a millimeter-wave sensor 100, avoids a false alarm problem of a radar as much as possible, and ensures accurate detection of the terminal. In addition, because the millimeter-wave sensor 100 implements a larger bandwidth and low sidelobe effect, the millimeter-wave sensor 100 included in the terminal can improve an advanced driving assistance system (ADAS) capability of the terminal in self-driving or assisted driving, and may be used in the internet of vehicles, for example, vehicle-to-everything (V2X), long term evolution-vehicle (LTE-V), and vehicle-to-vehicle (V2V)

In descriptions of embodiments of this application, it should be noted that, unless otherwise clearly specified and limited, the terms "installation", "connection to", and "connection" should be understood in a broad sense. For example, the connection may be a fixed connection, may be an indirect connection by using an intermediate medium, or may be an internal connection between two elements or an interaction relationship between two elements. For persons of ordinary skill in the art, specific meanings of the foregoing terms in embodiments of this application may be understood based on a specific situation.

An apparatus or element in embodiments of this application or an implied apparatus or element needs to have a specific direction and be constructed and operated in a specific direction, and therefore cannot be construed as a limitation to embodiments of this application. In descriptions of embodiments of this application, the meaning of "a plurality of" is two or more, unless otherwise precisely and specifically specified.

In the specification, claims, and accompanying drawings of embodiments of this application, the terms "first", "second", "third", "fourth", and the like (if present) are intended to distinguish between similar objects but do not necessarily indicate a specific order or sequence. It should be understood that the data termed in such a way is interchangeable in proper circumstances so that the embodiments of this application described herein can be implemented in an order other than the order illustrated or described herein. In addition, terms such as "include", "have", and any variations thereof are intended to cover non-exclusive inclusions, for example, a process, method, system, product, or device that includes a series of steps or units is not necessarily limited to those clearly listed steps or units, but may include other steps or units that are not clearly listed or inherent to such a process, method, product, or device.

Finally, it should be noted that the foregoing embodiments are merely intended for describing the technical solutions of embodiments of this application other than limiting embodiments of this application. Although embodiments of this application are described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of this application.

## Claims

1. An antenna, comprising a microstrip feeder disposed on one surface of a dielectric plate, wherein the antenna further comprises at least one of a first group of radiating elements located on a first side of the microstrip feeder or a second group of radiating elements located on a second side of the microstrip feeder, the first group of radiating elements comprises at least one first coupling stub, and the second group of radiating elements comprises at least one second coupling stub; and
a gap exists between the at least one first coupling stub and/or the at least one second coupling stub and the microstrip feeder

2. The antenna according to claim 1, wherein
a quantity of the at least one first coupling stub is greater than or equal to 3, and/or a quantity of the at least one second coupling stub is greater than or equal to 3; and
widths of gaps between the at least one first coupling stub and the microstrip feeder satisfy a rule of first decreasing and then increasing from a first end to a second end of the microstrip feeder; and/or
widths of gaps between the at least one second coupling stub and the microstrip feeder satisfy a rule of first decreasing and then increasing from a first end to a second end of the microstrip feeder

3. The antenna according to claim 1 or 2, wherein
a sum of the quantity of the at least one first coupling stub and the quantity of the at least one second coupling stub is greater than or equal to 3; and
the widths of the gaps between the at least one first coupling stub and the microstrip feeder and the widths of the gaps between the at least one second coupling stub and the microstrip feeder satisfy the rule of first decreasing and then increasing from the first end to the second end of the microstrip feeder

4. The antenna according to any one of claims 1 to 3, wherein
the at least one first coupling stub and the at least one second coupling stub are alternately distributed on two sides of the microstrip feeder.

5. The antenna according to any one of claims 1 to 4, wherein
the quantity of the at least one first coupling stub is greater than or equal to 3, and/or the quantity of the at least one second coupling stub is greater than or equal to 3; and
widths of the at least one first coupling stub satisfy a rule of first increasing and then decreasing from the first end to the second end of the microstrip feeder; and/or
widths of the at least one second coupling stub satisfy a rule of first increasing and then decreasing from the first end to the second end of the microstrip feeder.

6. The antenna according to any one of claims 1 to 4, wherein
the sum of the quantity of the at least one first coupling stub and the quantity of the at least one second coupling stub is greater than or equal to 3; and
the widths of the at least one first coupling stub and the widths of the at least one second coupling stub satisfy the rule of first increasing and then decreasing from the first end to the second end of the microstrip feeder.

7. The antenna according to any one of claims 1 to 6, wherein the first group of radiating elements and the second group of radiating elements comprise two groups of adjacent first coupling stubs and second coupling stubs, and distances between adjacent first coupling stubs and second coupling stubs in the two groups are different.

8. The antenna according to any one of claims 1 to 6, wherein distances between adjacent first coupling stubs and second coupling stubs in any two groups comprised in the first group of radiating elements and the second group of radiating elements are different.

9. The antenna according to any one of claims 1 to 8, wherein a distance between the first coupling stub and the second coupling stub that are adjacent to each other in any group comprised in the first group of radiating elements and the second group of radiating elements is d1 millimeters, d1 satisfies 0.4*λ_{g}* ≤ d1 ≤ 0.6*λ_{g}*, and *λ_{g}* is a wavelength of an electromagnetic wave transmitted in the dielectric plate by using the first coupling stub or the second coupling stub.

10. The antenna according to any one of claims 1 to 9, wherein a width of a gap between the microstrip feeder and any first coupling stub is greater than or equal to 0.076 mm and less than or equal to 0.9 mm; and/or
a width of a gap between the microstrip feeder and any second coupling stub is greater than or equal to 0.076 mm and less than or equal to 0.9 mm.

11. The antenna according to any one of claims 1 to 10, wherein
at least one matching stub is disposed on at least one side of one or more first coupling stubs of the at least one first coupling stub; and/or
at least one matching stub is disposed on at least one side of one or more second coupling stubs of the at least one second coupling stub; and
a gap exists between the matching stub and the microstrip feeder and between the matching stub and the one or more first coupling stubs and/or the one or more second coupling stubs.

12. The antenna according to any one of claims 1 to 11, wherein
at least one matching stub is disposed on at least one side of any first coupling stub of the at least one first coupling stub and any second coupling stub of the at least one second coupling stub; and
a gap exists between the matching stub and the microstrip feeder and between the matching stub and the any first coupling stub and the any second coupling stub.

13. The antenna according to any one of claims 1 to 12, wherein the matching stubs are disposed on upper and lower sides of the any first coupling stub and the any second coupling stub.

14. The antenna according to any one of claims 1 to 13, wherein a length of the at least one first coupling stub and a length of the at least one second coupling stub are greater than or equal to 0.4*λ_{g}* and less than or equal to 0.6*λ_{g}*; or
a length of the any first coupling stub and a length of the any second coupling stub are greater than or equal to 0.4*λ_{g}* and less than or equal to 0.6*λ_{g}*, and *λ_{g}* is a wavelength of an electromagnetic wave transmitted in the dielectric plate by using the first coupling stub or the second coupling stub.

15. The antenna according to any one of claims 1 to 14, wherein a width of the at least one first coupling stub and a width of the at least one second coupling stub are greater than or equal to 0.076 mm and less than or equal to 0.9 mm; or
a width of the any first coupling stub and a width of the any second coupling stub are greater than or equal to 0.076 mm and less than or equal to 0.9 mm.

16. The antenna according to any one of claims 1 to 15, wherein the at least one first coupling stub or the at least one second coupling stub or both are rectangular or trapezoidal patches, or the any first coupling stub or the any second coupling stub or both are rectangular or trapezoidal patches.

17. The antenna according to any one of claims 1 to 16, wherein a quantity of the first coupling stubs is 5, and/or a quantity of the second coupling stubs is 5.

18. A millimeter-wave sensor, comprising at least a circuit board, a metal ground layer disposed on a first surface of the circuit board, and at least one antenna array disposed on a second surface of the circuit board, wherein one or more antenna arrays in the at least one antenna array comprise at least one antenna according to any one of claims 1 to 17.

19. The millimeter-wave sensor according to claim 18, wherein the at least one antenna array comprises at least one transmit antenna array and at least one receive antenna array, any transmit antenna array and any receive antenna array comprise at least one antenna, and a microstrip feeder of the antenna is electrically connected to a feed of the circuit board.

20. The millimeter-wave sensor according to claim 18 or 19, wherein a thickness of the circuit board is 5 Mil.

21. The millimeter-wave sensor according to any one of claims 18 to 20, wherein a dielectric constant of the circuit board is greater than or equal to 2 and less than or equal to 4.

22. A terminal, comprising at least a body and at least one sensor disposed on the body, wherein the at least one sensor comprises at least one millimeter-wave sensor according to any one of claims 18 to 21.

23. A method for preparing an antenna, comprising:
forming at least one microstrip feeder on one surface of a dielectric plate; and
forming a first group of radiating elements on a first side of the microstrip feeder and/or forming a second group of radiating elements on a second side of the microstrip feeder, wherein the first group of radiating elements comprises at least one first coupling stub, and the second group of radiating elements comprises at least one second coupling stub; and
a gap is formed between the at least one first coupling stub and/or the at least one second coupling stub and the microstrip feeder

24. The method according to claim 23, further comprising:
forming a metal ground layer on the other surface of the dielectric plate.

25. The method according to claim 23 or 24, wherein
a quantity of the at least one first coupling stub is greater than or equal to 3, and/or a quantity of the at least one second coupling stub is greater than or equal to 3; and
widths of gaps between the at least one first coupling stub and the microstrip feeder satisfy a rule of first decreasing and then increasing from a first end to a second end of the microstrip feeder; and/or
widths of gaps between the at least one second coupling stub and the microstrip feeder satisfy a rule of first decreasing and then increasing from a first end to a second end of the microstrip feeder

26. The method according to claim 23 or 24, wherein
a sum of a quantity of the at least one first coupling stub and a quantity of the at least one second coupling stub is greater than or equal to 3; and
widths of gaps between the at least one first coupling stub and the microstrip feeder and widths of gaps between the at least one second coupling stub and the microstrip feeder satisfy a rule of first decreasing and then increasing from a first end to a second end of the microstrip feeder.

27. The method according to claim 23 to 26, wherein
the at least one first coupling stub and the at least one second coupling stub are alternately distributed on two sides of the microstrip feeder.

28. The method according to any one of claims 23 to 25 and claim 27, wherein
the quantity of the at least one first coupling stub is greater than or equal to 3, and/or the quantity of the at least one second coupling stub is greater than or equal to 3; and
widths of the at least one first coupling stub satisfy a rule of first increasing and then decreasing from the first end to the second end of the microstrip feeder; and/or
widths of the at least one second coupling stub satisfy a rule of first increasing and then decreasing from the first end to the second end of the microstrip feeder.

29. The method according to any one of claims 23 and 24 and claims 26 and 27, wherein
the sum of the quantity of the at least one first coupling stub and the quantity of the at least one second coupling stub is greater than or equal to 3; and
the widths of the at least one first coupling stub and the widths of the at least one second coupling stub satisfy the rule of first increasing and then decreasing from the first end to the second end of the microstrip feeder.

30. The method according to any one of claims 23 to 29, wherein the first group of radiating elements and the second group of radiating elements comprise two groups of adjacent first coupling stubs and second coupling stubs, and distances between adjacent first coupling stubs and second coupling stubs in the two groups are different.
